# EUROPEAN PATENT APPLICATION

(11) **EP 4 727 314 A1**
(43) Date of publication of application: **15.04.2026**
(21) Application number: 25751088.3
(22) Date of filing: 14.01.2025
(51) Int. Cl.: H10K 59/131, H10K 59/126, H10K 59/12

(54) **DISPLAY SUBSTRATE AND DISPLAY APPARATUS**

(30) Priority: 07.02.2024 CN 202410175990
(71) Applicant: Boe Technology Group Co., Ltd., Beijing 100015 (CN); Chongqing Boe Display Technology Co., Ltd., Beibei District, Chongqing 400714 (CN)
(72) Inventor: HE, Xiaoling, Beijing 100176 (CN); ZENG, Chao, Beijing 100176 (CN); WANG, Rui, Beijing 100176 (CN); HU, Ming, Beijing 100176 (CN); ZHANG, Shouqiang, Beijing 100176 (CN); ZHANG, Runxin, Beijing 100176 (CN)
(74) Representative: Hoffmann Eitle
(86) International application number: PCT/CN2025/072247
(87) International publication number: WO 2025/167486

(57) **Abstract**

A display substrate, which has a display area and a binding area, the binding area being located on one side of the display area in a first direction. The display substrate comprises a base, a plurality of signal lines and a light-shielding layer, wherein the plurality of signal lines are located on the base, the signal lines are at least located in the display area, and the plurality of signal lines include a plurality of first-type signal lines and a plurality of first-type fan-out lines, the first-type signal lines receiving constant-voltage electrical signals; the light-shielding layer is located on the side of the plurality of signal lines away from the base, and is located in the display area, and the light-shielding layer comprises a plurality of first openings; the display area comprises a primary display area and a secondary display area located on one side of the primary display area, the light transmittance of the secondary display area being greater than the light transmittance of the primary display area, and the plurality of first openings being located in the secondary display area; the orthographic projections of the plurality of first-type signal lines and the plurality of first-type fan-out lines on the base do not overlap the orthographic projections of the plurality of first openings on the base; and each first-type fan-out line is located between two adjacent first-type signal lines.

## Description

This application claims priority to Chinese Patent Application No. 202410175990.6, filed on February 7, 2024, which is incorporated herein by reference in its entirety.

### TECHNICAL FIELD

The present disclosure relates to the field of display technologies, and in particular, to a display substrate and a display apparatus.

### BACKGROUND

The organic light-emitting diode (OLED) display technology is a technology that uses luminescent materials to emit light under current drive to achieve display. The OLED displays have ultra-lightness, ultra-thinness, high brightness, wide viewing angle, low voltage, low power consumption, fast response, high definition, vibration resistance, being bendable, low cost, simple process, using limited raw materials, high luminous efficiency, wide temperature range and other advantages.

### SUMMARY

In an aspect, a display substrate is provided. The display substrate has a display area and a bonding region, and the bonding region is located on a side of the display area in a first direction. The display substrate includes a substrate, a plurality of signal lines and a light-shading layer. The plurality of signal lines are located on the substrate. The signal lines are located at least in the display area. The plurality of signal lines include a plurality of first-type signal lines and a plurality of first-type fan-out lines. The first-type signal lines receive a constant voltage electrical signal. The light-shading layer is located on a side of the plurality of signal lines away from the substrate and located in the display area. The light-shading layer includes a plurality of first openings. The display area includes a main display region and a secondary display region located on a side of the main display region. Light transmittance of the secondary display region is greater than light transmittance of the main display region. The plurality of first openings are located in the secondary display region. Orthographic projections of the plurality of first-type signal lines and the plurality of first-type fan-out lines on the substrate and orthogonal projections of the plurality of first openings on the substrate have no overlap. A first-type fan-out line is located between two adjacent first-type signal lines.

In some embodiments, the first-type signal lines extend in the first direction, and the first-type fan-out lines extend in the first direction. The first-type fan-out line located between the two adjacent first-type signal lines and the two adjacent first-type signal lines have substantially equal or equal distances.

In some embodiments, the two adjacent first-type signal lines located on opposite sides of the first-type fan-out line are arranged substantially symmetrically or symmetrically with respect to the first-type fan-out line.

In some embodiments, the display substrate further includes a plurality of pixel circuits. The plurality of pixel circuits are arranged in a plurality of rows and a plurality of columns. Each row of pixel circuits is arranged in a second direction, and each column of pixel circuits is arranged in the first direction, the second direction intersects the first direction. The two adjacent first-type signal lines are located on both sides of the first-type fan-out line constitute a first-type signal line group, and the two first-type signal lines in the first-type signal line group are connected. A first-type signal line is electrically connected to a column of pixel circuits.

In some embodiments, the plurality of signal lines further include a plurality of first connecting lines. The first connecting lines extend in the second direction. A first connecting line connects the two first-type signal lines in the first-type signal line group.

In some embodiments, the first-type signal lines include a first voltage signal line.

In some embodiments, the plurality of signal lines further include a plurality of second-type signal lines. The second-type signal lines and the first-type signal lines are configured to receive the same electrical signal. The second-type signal lines have same or substantially same extension directions as the first-type signal lines. Compared with the second-type signal lines, the first-type signal lines are closer to a center line of the display area extending in the first direction.

In some embodiments, the plurality of signal lines further include a plurality of second-type fan-out lines and a plurality of data signal lines. The data signal lines extend in the first direction, the second-type fan-out lines extend in a second direction, and the second-type fan-out lines are located in the display area. A second-type fan-out line is connected to the first-type fan-out line. A data signal line is connected to the second-type fan-out line.

In some embodiments, the display substrate further includes a plurality of pixel circuits. The plurality of pixel circuits are arranged in a plurality of rows and a plurality of columns. Each row of pixel circuits is arranged in a second direction, and each column of pixel circuits is arranged in the first direction, the second direction intersects the first direction. The plurality of signal lines further include a plurality of third-type signal lines. The third-type signal lines are configured to receive an initial signal; and the third-type signal lines extend in the second direction. Two adjacent rows of pixel circuits are connected to a same third-type signal line.

In some embodiments, the two adjacent rows of pixel circuits and the same third-type signal line have equal or substantially equal distances therebetween.

In some embodiments, the plurality of third-type signal lines include a plurality of first initial signal lines, a plurality of second initial signal lines and a plurality of third initial signal lines.

In some embodiments, the plurality of signal lines further include a plurality of second connecting lines. The second connecting lines extend in the first direction; and a second connecting line is connected to a third-type signal line.

In some embodiments, the plurality of signal lines further include a plurality of second connecting lines. The second connecting lines extend in the first direction. A second connecting line includes at least one break and a plurality of sub-lines. A break is directly opposite to a first opening, and a dimension of the break in the first direction is greater than or equal to a dimension of the first opening in the first direction. Each break is provided with sub-lines at opposite sides thereof; and a sub-line is connected to a third-type signal line.

In some embodiments, the plurality of signal lines further include a plurality of data signal lines, and the second connecting line is located between two adjacent data signal lines.

In some embodiments, the display substrate includes a first source-drain conductive layer and a second source-drain conductive layer that are arranged sequentially on a side of the substrate. The display substrate further includes a plurality of second-type fan-out lines and a plurality of data signal lines. The plurality of second-type fan-out lines are located in the first source-drain conductive layer; and the plurality of first-type signal lines, the plurality of first-type fan-out lines and the plurality of data signal lines are located in the second source-drain conductive layer.

In some embodiments, the display substrate further includes a first gate conductive layer and a second gate conductive layer that are arranged sequentially between the substrate and the first source-drain conductive layer. The first gate conductive layer is located between the substrate and the second gate conductive layer. The display substrate further includes a plurality of first connecting lines, a plurality of second connecting lines, and a plurality of third-type signal lines. The plurality of third-type signal lines include a plurality of first initial signal lines, a plurality of second initial signal lines and a plurality of third initial signal lines. The plurality of second connecting lines are located in the second source-drain conductive layer. The plurality of first initial signal lines are located in the first source-drain conductive layer. The plurality of second initial signal lines and the plurality of first connecting lines are located in the first gate conductive layer, and the plurality of third initial signal lines are located in the second gate conductive layer.

In some embodiments, the display substrate further includes a plurality of filter portions. The light-shading layer further includes a plurality of second openings. The plurality of second openings are located in the main display region, and a filter portion is located in a second opening.

In some embodiments, the display substrate further includes a plurality of light-emitting devices and an encapsulation layer. The plurality of light-emitting devices are located on a side of the plurality of signal lines away from the substrate. The encapsulation layer is disposed between the light-shading layer and the plurality of light-emitting devices.

In another aspect, a display apparatus is provided. The display apparatus includes the display substrate as described in any of the above embodiments and an optical element. The optical element is located on a non-light-exit side of the display substrate and located in the secondary display region of the display substrate.

### BRIEF DESCRIPTION OF THE DRAWINGS

In order to describe technical solutions in the present disclosure more clearly, accompanying drawings to be used in some embodiments of the present disclosure will be introduced briefly below. Obviously, the accompanying drawings to be described below are merely accompanying drawings of some embodiments of the present disclosure, and a person of ordinary skill in the art may obtain other drawings according to these drawings. In addition, the accompanying drawings to be described below may be regarded as schematic diagrams, but are not limitations on an actual size of a product to which the embodiments of the present disclosure relate.
FIG. 1 is a schematic diagram of a display apparatus, in accordance with some embodiments of the present disclosure;
FIG. 2 is a schematic diagram of another display apparatus, in accordance with some embodiments of the present disclosure;
FIG. 3 is a structural diagram of another display apparatus, in accordance with some embodiments of the present disclosure;
FIG. 4 is a structural diagram of a display substrate, in accordance with some embodiments of the present disclosure;
FIG. 5 is a structural diagram of some film layers in a display substrate, in accordance with an implementation of the present disclosure;
FIG. 6 is a structural diagram of some film layers in a display substrate, in accordance with some embodiments of the present disclosure;
FIG. 7 is a structural diagram of some other film layers in a display substrate, in accordance with some embodiments of the present disclosure;
FIG. 8 is a structural diagram of some other film layers in a display substrate, in accordance with some embodiments of the present disclosure;
FIG. 9 is a structural diagram of third-type signal lines and second connecting lines in a display substrate, in accordance with some embodiments of the present disclosure;
FIG. 10 is an equivalent circuit diagram of a pixel driving circuit and a light-emitting device, in accordance with some embodiments of the present disclosure;
FIG. 11 is a structural diagram of some other film layers in a display substrate, in accordance with some embodiments of the present disclosure;
FIG. 12 is a structural diagram of some other film layers in a display substrate, in accordance with some embodiments of the present disclosure;
FIG. 13 is a structural diagram of some other film layers in a display substrate, in accordance with some embodiments of the present disclosure;
FIG. 14 is a structural diagram of some other film layers in a display substrate, in accordance with some embodiments of the present disclosure;
FIG. 15 is a structural diagram of some other film layers in a display substrate, in accordance with some embodiments of the present disclosure;
FIG. 16 is a structural diagram of some other film layers in a display substrate, in accordance with some embodiments of the present disclosure; and
FIG. 17 is a structural diagram of some other film layers in a display substrate, in accordance with some embodiments of the present disclosure.

### DETAILED DESCRIPTION

Technical solutions in some embodiments of the present disclosure will be described clearly and completely with reference to the accompanying drawings below. Obviously, the described embodiments are merely some but not all embodiments of the present disclosure. All other embodiments obtained by a person of ordinary skill in the art based on the embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed as open and inclusive, i.e., "including, but not limited to". In the description of the specification, the terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described herein may be included in any one or more embodiments or examples in any suitable manner.

Hereinafter, the terms such as "first" and "second" are used for descriptive purposes only, and are not to be construed as indicating or implying the relative importance or implicitly indicating the number of indicated technical features. Thus, features defined with "first" or "second" may explicitly or implicitly include one or more of the features. In the description of the embodiments of the present disclosure, the term "a plurality of" or "the plurality of" means two or more unless otherwise specified.

The phrase "A and/or B" includes the following three combinations: only A, only B, and a combination of A and B.

The term "about", "substantially" or "approximately" as used herein includes a stated value and an average value within an acceptable range of deviation of a particular value. The acceptable range of deviation is determined by a person of ordinary skill in the art in consideration of the measurement in question and errors associated with the measurement of a particular quantity (i.e., limitations of the measurement system).

The term such as "perpendicular" or "equal" as used herein includes a stated condition and a condition similar to the stated condition. A range of the similar condition is within an acceptable range of deviation. The acceptable range of deviation is determined by a person of ordinary skill in the art in view of measurement in question and errors associated with the measurement of a particular quantity (i.e., limitations of the measurement system). For example, the term "perpendicular" includes absolute perpendicularity and approximate perpendicularity, and an acceptable range of deviation of the approximate perpendicularity may also be a deviation within 5°; and the term "equal" includes absolute equality and approximate equality, and an acceptable range of deviation of the approximate equality may be a difference between two equals being less than or equal to 5% of either of the two equals.

It will be understood that when a layer or element is referred to as being on another layer or substrate, the layer or element may be directly on the another layer or substrate, or there may be intermediate layer(s) between the layer or element and the another layer or substrate.

Exemplary embodiments are described herein with reference to sectional views and/or plane views as idealized exemplary drawings. In the accompanying drawings, thicknesses of layers and sizes of areas/regions are enlarged for clarity. Variations in shapes relative to the accompanying drawings due to, for example, manufacturing technologies and/or tolerances may be envisaged. Therefore, the exemplary embodiments should not be construed to be limited to the shapes of areas/regions shown herein, but to include deviations in the shapes due to, for example, manufacturing. For example, an etched area/region shown in a rectangular shape generally has a feature of being curved. Therefore, the areas/regions shown in the accompanying drawings are schematic in nature, and their shapes are not intended to show actual shapes of the areas/regions in a device, and are not intended to limit the scope of the exemplary embodiments.

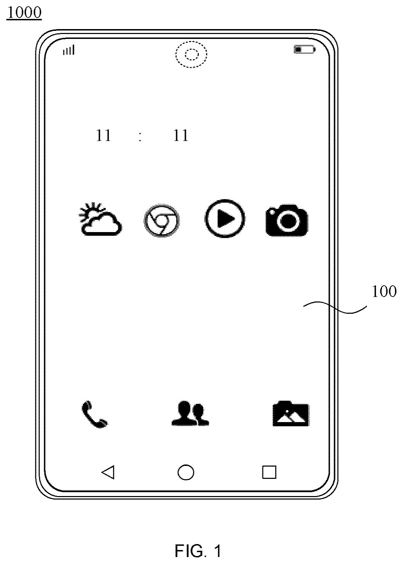

As shown in FIG. 1, some embodiments of the present disclosure provide a display apparatus 1000. The display apparatus 1000 may be any display apparatus 1000 that displays images whether in motion (such as a video) or fixed (such as a still image), and regardless of text or image. More specifically, it is expected that the display apparatus 1000 in the embodiments may be implemented in or associated with a variety of electronic devices. The variety of electronic devices may include (but are not limit to), for example, mobile phones, wireless devices, personal digital assistants (PDAs), hand-held or portable computers, global positioning system (GPS) receivers/navigators, cameras, MPEG-4 Part 14 (MP4) video players, video cameras, game consoles, watches, clocks, calculators, TV monitors, flat-panel displays, computer monitors, car displays (e.g., odometer displays), navigators, cockpit controllers and/or displays, camera view displays (e.g., display of rear view camera in vehicles), electronic photos, electronic billboards or signs, projectors, architectural structures, packaging and aesthetic structures (e.g., displays for displaying an image of a piece of jewelry), etc.

In some examples, as shown in FIG. 1, the display apparatus 1000 includes a display substrate 100 and a frame. The display substrate 100 is embedded in the frame.

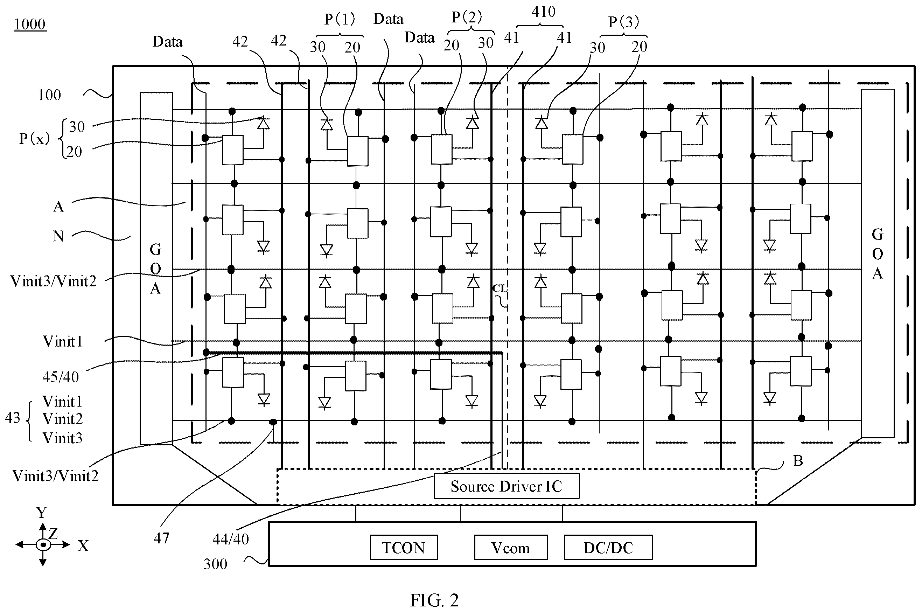

In some embodiments, referring to FIG. 2, the display apparatus 1000 further includes a driver circuit board 300. The driver circuit board 300 may include, for example, a timing controller (TCON), a power supply management chip DC/DC, an adjustable resistor voltage-dividing circuit (for generating Vcom) and other driver circuits. The driver circuit board 300 may further include other circuit structures, which are not listed one by one here. The driver circuit board 300 is electrically connected to the display substrate 100 and is used to transmit control signals to the display substrate 100, thereby driving the display substrate 100 to achieve image display.

As shown in FIG. 2, the display substrate 100 has a display area A and a peripheral area N located on at least one side of the display area A in a second direction X.

In some embodiments, as shown in FIG. 2, the peripheral area N is disposed around the display area A. The peripheral area N may be provided therein with gate driver circuits (e.g., gate drivers on array, GOAs), control signal lines (e.g., clock signal lines and power supply voltage signal lines), and a bonding driver chip (e.g., source driver IC, source driver chip). For example, the gate driver circuits are disposed in the peripheral area N and on opposite sides of the display area A. The functions of the peripheral area N include but are not limited thereto.

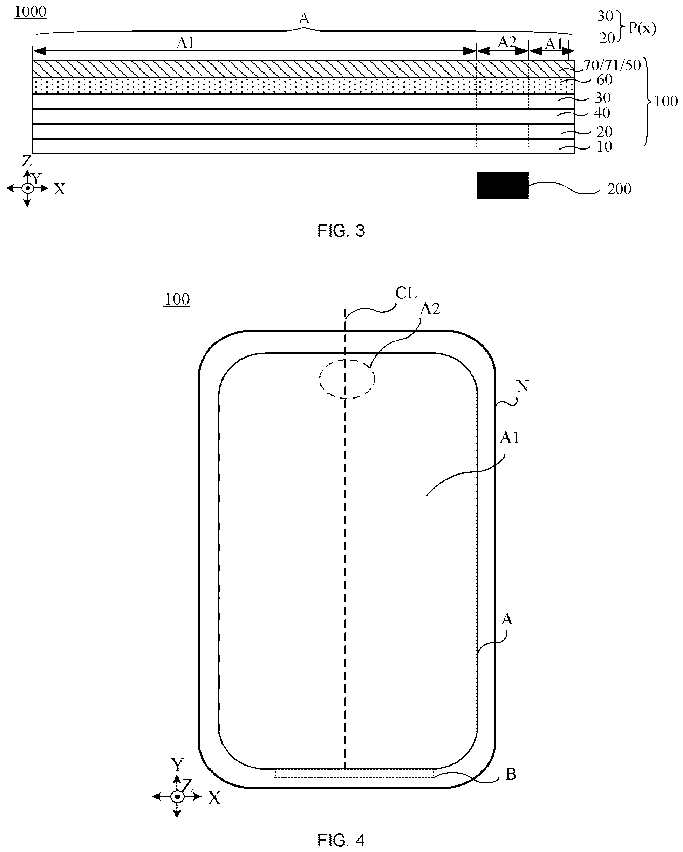

For example, as shown in FIGS. 2 and 4, the peripheral area N includes a bonding region B, and the bonding region B is located on a side of the display area A in the second direction X. The bonding region B is adjacent to a side edge of the display area A. For example, the bonding region B is adjacent to a lower side edge of the display area A. The display substrate 100 is connected to an external driver in the bonding region B.

For example, the bonding region B is configured to lead out signal lines (e.g., data signal lines Data, first voltage signal lines VDD and a common voltage signal line VSS mentioned below) and bond the signal lines to the driver circuit board 300. The bonding region B is located at a side, for being bonded to the driver circuit board 300, of the display substrate 100. The above bonding driver chip may be disposed in the bonding region B.

For example, the display substrate 100 includes a plurality of pixels P disposed in the display area A, and each pixel P includes at least three sub-pixels P(x).

For example, the plurality of pixels P are arranged in a plurality of rows and a plurality of columns.

For example, as shown in FIG. 2, the display area A is an area of the display substrate 100 for displaying images, the sub-pixel P(x) is the smallest light-emitting unit in the display substrate 100, and the sub-pixel P(x) is used for displaying images.

In some examples, a plurality of sub-pixels P(x) above emit light of the same color. For example, the plurality of sub-pixels P(x) all emit white light, red light, green light, blue light or other color light. In this case, the color light emitted by the sub-pixel P(x), after passing through a color filter layer, remains the same color light for exit or is converted into other color light for exit. Therefore, in a case where the plurality of sub-pixels P(x) emit the same color light, the display substrate 100 may achieve multi-color light exit.

In some other examples, the plurality of sub-pixels P(x) emit light of different colors. For example, the plurality of sub-pixels P(x) include a red sub-pixel for emitting red light, a green sub-pixel for emitting green light, and a blue sub-pixel for emitting blue light, thereby realizing multi-color light exit of the display substrate 100.

It will be noted that each pixel P includes at least three sub-pixels P(x), that is, each pixel P may include three, four or more sub-pixels P(x). Multiple sub-pixels P(x) included in each pixel P may be a row of sub-pixels P(x), a column of sub-pixels P(x) or a group of sub-pixels P(x), where the group of sub-pixels P(x) may be multiple adjacent sub-pixels P(x), and the multiple adjacent sub-pixels P(x) are arranged in a row, a column, an L shape, a rectangle, a rhombus or the like.

Moreover, multiple sub-pixels P(x) included in each pixel P may have the same or not exactly the same light-emitting areas. The above description is only for illustrative purposes and is not intended to limit the embodiments of the present disclosure, and adaptive designs may be specifically made depending on actual needs.

As shown in FIG. 3, the display substrate 100 may further include an encapsulation layer 60 disposed on a light-exit side of the plurality of sub-pixels P(x) and a functional stack layer 70 disposed on the encapsulation layer 60.

For example, the functional stack layer 70 may include a color filter layer 71, that is, the display substrate 100 adopts a color filter on encapsulation (CF on Encapsulation, COE) structure. The functional stack layer 70 may further include one or more of a touch function layer, an anti-reflection layer, a hardening layer and an anti-fingerprint layer, so that the display substrate 100 may achieve corresponding functions. The embodiments of the present disclosure do not specifically limit the type and the quantity of the functional stack layer.

The display substrate 100 including the COE structure has advantages of high contrast, low power consumption and a wide color gamut, and may have a reduced thickness, which is conducive to achieving a light and thin design of the display substrate 100. In addition, the display substrate 100 has good bending performance, so that the display substrate 100 and the display apparatus 1000 may achieve flexible display.

In some embodiments, as shown in FIG. 3, the display apparatus 1000 may further include an optical element 200. The optical element 200 is located on a non-light-exit side of the display substrate 100. The light-exit side of the display substrate 100 refers to a side of the display substrate 100 where images may be displayed. The non-light-exit side of the display substrate 100 refers to a side of the display substrate 100 opposite to the light-exit side.

The display area A refers to an area of the display substrate 100 for displaying images.

The display area A may be in a shape of a rectangle, a rounded rectangle or the like. The rounded rectangle refers to a rectangle with four rounded corners.

As shown in FIG. 4, the display area A includes a main display region A1 and a secondary display region A2, and the secondary display region A2 is located on at least one side of the main display region A1. In the solution, the secondary display region A2 is located on a side of the main display region A1, which may mean that the secondary display region A2 is located on a side of a main body part of the main display region A1, and the secondary display region A2 may be surrounded or half surrounded by the main display region A1.

For example, the secondary display region A2 may be in a shape of a circle, an ellipse or a rectangle.

For example, the secondary display region A2 may be located on one or more sides of the main display region A1.

For example, in a case where the display area A is in a shape of a rectangle, the secondary display region A2 may be located at any position in the middle of the rectangle, alternatively, the secondary display region A2 may be located at a position proximate to any corner of the rectangle, alternatively, the secondary display region A2 may be located at a position proximate to any side of the rectangle.

The following description will be made by considering an example where the secondary display region A2 is located close to or facing a center line CL of the display A in the first direction Y.

For example, portions of the display substrate 100 located in the main display region A1 and the secondary display region A2 may both be used for image display.

For example, the light transmittance of the secondary display region A2 is greater than the light transmittance of the main display region A1. For example, a pixel density of a plurality of pixels P(x) located in the main display region A1 of the display substrate 100 is greater than a pixel density of a plurality of pixels P(x) located in the secondary display region A2 of the display substrate 100.

As shown in FIG. 3, the optical element 200 is located in the secondary display region A2 of the display substrate 100. Since the light transmittance of the secondary display region A2 is greater than the light transmittance of the main display region A1, the external light is less lost after passing through the secondary display region A2, so that the optical element 200 may obtain sufficient light, thereby avoiding affecting the function of the optical element 200.

For example, as shown in FIG. 3, the optical elements 200 may be a camera, a fingerprint recognition sensor, an infrared sensor, and the like.

When the optical elements 200 work, the external light need to pass through the secondary display region A2 to be incident onto the optical elements 200 to activate the corresponding functions. The embodiments of the present disclosure are described by considering an example in which the optical element 200 is a camera.

For example, during working of the camera, the external light may pass through a portion of the display substrate located in the secondary display region A2. In this way, the camera may collect the light to achieve the function of photographing or picture recording. For example, when the camera works (e.g., taking a selfie by a user), the secondary display region A2 may present a black image, and the main display region A1 may present the user's selfie picture, which shows the location of the camera more clearly. Alternatively, a whole of the secondary display region A2 and the main display region A1 present the user's selfie picture without showing the location of the camera.

For example, when the camera does not work, portions of the display substrate located in the secondary display region A2 and the main display region A1 may both display images, so that the entire display substrate and the entire display apparatus 1000 may display images.

In some examples, the above color filter layer 71 includes a light-shading layer 50.

For example, the light-shading layer 50 is a black matrix. A material of the black matrix includes an opaque material. The light-shading layer 50 includes a plurality of first openings 51 and a plurality of second openings 52. The top view of the light-shading layer 50 may be substantially in a shape of a mesh structure, and the first openings 51 and the second openings 52 constitute grids of the mesh structure. The first openings 51 are located in the secondary display region A2 of the display substrate 100. Since the optical elements 200 are located in the secondary display region A2, and the plurality of first openings 51 correspond to the optical elements 200, the external light may pass through the display substrate 100 through the first openings 51 to enter the optical elements 200, so that the optical elements 200 may collect the external light.

For example, the plurality of first openings 51 are arranged in an array, and the plurality of second openings 52 are also arranged in an array.

In some examples, the first opening 51 and the second opening 52 may be in the same or substantially the same shapes.

For example, the first opening 51 is in a shape of a rectangle, a trapezoid, a circle, a rounded rectangle, an ellipse, or the like.

In some other examples, the first opening 51 and the second opening 52 may be in different shapes.

The area relationship between the first opening 51 and the second opening 52 may be set depending on actual needs, and limitations are not made in the embodiments of the present disclosure.

For example, an area of the first opening 51 is greater than or equal to an area of the second opening 52.

As another example, an area of the first opening 51 is less than an area of the second opening 52.

For example, the color filter layer 71 further includes a plurality of filter portions 53. A filter portion 53 is located in a second opening 52. The plurality of second openings 52 are located in the main display region A1 of the display substrate 100. Thus, the filter portions 53 are also located in the main display region A1 of the display substrate 100.

The filter portion 53 may transmit light within a certain wavelength range, and a filter portion 53 is provided corresponding to a light-emitting device 30.

The plurality of filter portions 53 may include at least a plurality of first filter sub-portions, a plurality of second filter sub-portions and a plurality of third filter sub-portions. The first filter sub-portion may transmit red light, the second filter sub-portion may transmit green light, and the third filter sub-portion may transmit blue light.

For example, light emitted by the light-emitting device 30 passes through the encapsulation layer 60 to enter the corresponding filter portion 53 in the light-shading layer 50, and passes through the filter portion 53 to exit from the display substrate 100.

In some embodiments, as shown in FIG. 3, the display substrate 100 includes a substrate 10, a plurality of pixel circuits 20 and a plurality of light-emitting devices 30.

The type of the substrate 10 varies and may be set depending on actual needs.

For example, the substrate 10 may be a rigid substrate 10. The rigid substrate 10 may be a glass substrate, a polymethyl methacrylate (PMMA) substrate or the like.

For example, the substrate 10 may be a flexible substrate 10. The flexible substrate 10 may be a polyethylene terephthalate (PET) substrate 10, a polyethylene naphthalate (PEN) substrate 10, a polyimide (PI) substrate 10 or the like. In this case, the display substrate 100 may, for example, achieve flexible display.

As shown in FIG. 2, the plurality of pixel circuits 20 are disposed on a side of the substrate 10. The plurality of pixel circuits 20 are arranged in a plurality of rows and a plurality of columns. Each row of pixel circuits 20 is arranged in the second direction X, and each column of pixel circuits 20 is arranged in the first direction Y. Each row of pixel circuits 20 includes multiple pixel circuits 20 arranged at intervals in second direction X, and each column of pixel circuits 20 includes multiple pixel circuits 20 arranged at intervals in the first direction Y. That is, the first direction Y is a column direction in which the multiple pixel circuits 20 are arranged, and the second direction X is a row direction in which the multiple pixel circuits 20 are arranged. The first direction Y and the second direction X intersect.

For example, an included angle between the first direction Y and the second direction X is 75°, 80°, 90°, 95°, 105° or 120°.

In addition, in FIG. 2, Z represents a third direction, and the third direction Z is perpendicular to a plane where the substrate 10 is located. For example, the third direction Z is perpendicular to both the first direction Y and the second direction X.

The light-emitting device 30 includes, but is not limited to, an organic light-emitting diode (OLED), a mini light-emitting diode (mini LED), a micro light-emitting diode (micro LED), and the like.

The following will be illustrated by considering an example where the light-emitting device 30 includes the OLED.

The light-emitting device 30 includes a first electrode, a light-emitting functional layer and a second electrode that are sequentially stacked. The light-emitting functional layer may include a light-emitting layer. Optionally, the light-emitting functional layer may further include at least one of a hole injection layer, a hole transport layer, an electron transport layer and an electron injection layer.

For example, the first electrode is one of an anode and a cathode, and the second electrode is the other of the anode and the cathode, which is not limited in the embodiments of the present disclosure.

For convenience of description, the embodiments of the present disclosure will be described by considering an example where the first electrode is the anode and the second electrode is the cathode.

A pixel circuit 20 is connected a light-emitting device 30; alternatively, a pixel circuit 20 is connected to multiple light-emitting devices 30. The pixel circuit 20 and the light-emitting device 30 connected thereto constitute the aforementioned sub-pixel P(x). The pixel circuit 20 may generate a driving signal (e.g., driving current). Each light-emitting device 30 may emit light under a driving action of a driving signal generated by a pixel circuit 20 connected thereto. The light emitted by all light-emitting devices 30, after exiting through the filter portions of the color filter layer 71, forms a plurality of light rays of different colors. The plurality of light rays of different colors cooperate with one another, so that the display substrate 100 and the display apparatus 1000 may realize the display function.

In some examples, as shown in FIGS. 2 and 3, the display substrate 100 has a display area A and a bonding region B. The bonding region B is located on a side of the display area A in the first direction Y. The display substrate 100 further includes a plurality of signal lines 40.

The plurality of signal lines 40 are located on the substrate 10. The plurality of signal lines 40 are located on a side of the pixel circuits 20 away from the substrate 10 and between the plurality of light-emitting devices 30 and the pixel circuits 20. The light-emitting devices 30 are located on a side of the plurality of signal lines 40 away from the substrate 10.

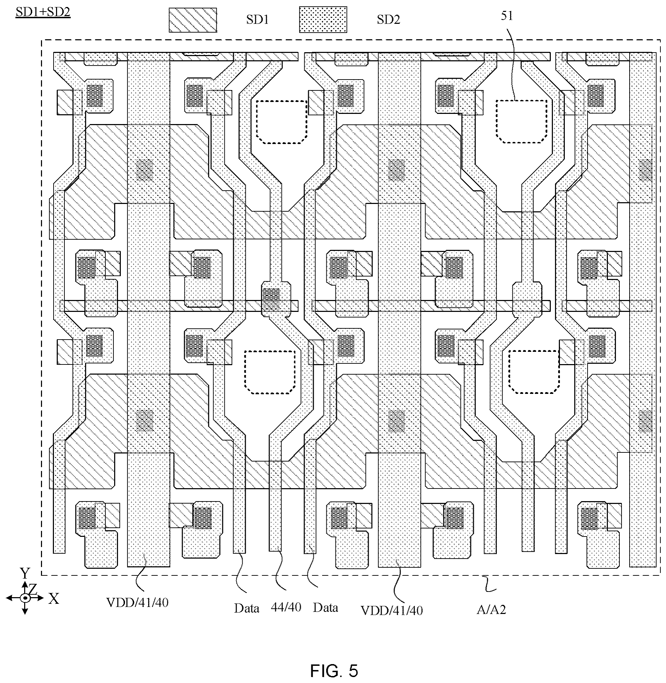

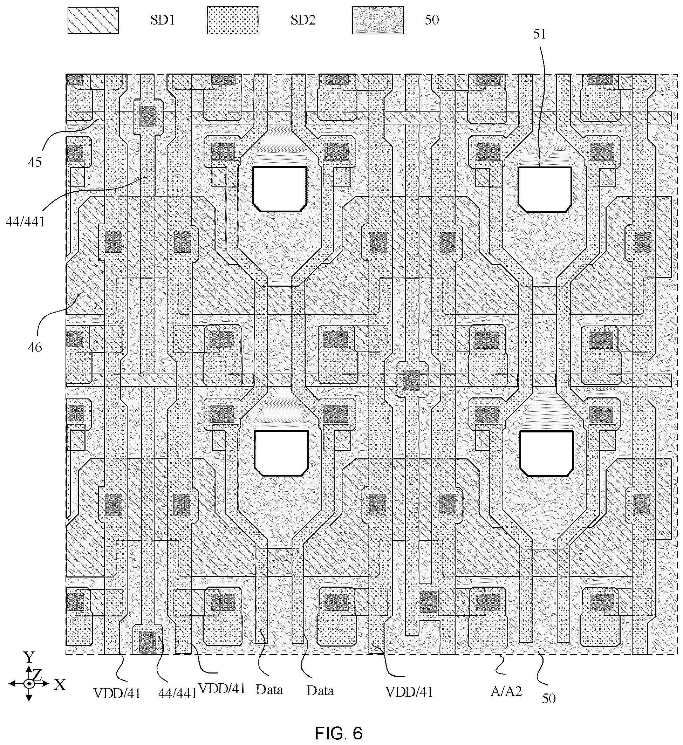

As shown in FIGS. 5 and 6, the plurality of signal lines 40 include a plurality of first-type signal lines 41 and a plurality of first-type fan-out lines 44. The first-type signal line 41 receives a constant voltage electric signal. For example, the first-type signal lines 41 and the first-type fan-out lines 44 are provided in the same layer.

As shown in FIG. 2, the signal lines 40 are at least located in the display area A. For example, both the first-type signal lines 41 and the first-type fan-out lines 44 extend from the display area A to the bonding region B, and are connected to the driver circuit board 300 close to the bonding region B.

As shown in FIGS. 3 and 6, the light-shading layer 50 is located on a side of the plurality of signal lines 40 away from the substrate 10. The light-shading layer 50 constitutes a portion of the color filter layer 71. The light-shading layer 50 includes a plurality of first openings 51. The plurality of first openings 51 are arranged at intervals and located in the secondary display region A2.

Orthographic projections of the plurality of first-type signal lines 41 and the plurality of first-type fan-out lines 44 on the substrate 10 and orthogonal projections of the plurality of first openings 51 on the substrate 10 have no overlap. For example, there is no intersection between the orthographic projections of the plurality of first-type signal lines 41 and the plurality of first-type fan-out lines 44 on the substrate 10 and edges of the orthogonal projections of the first openings 51 on the substrate 10, and the orthographic projections of the plurality of first-type signal lines 41 and the plurality of first-type fan-out lines 44 on the substrate 10 are located outside the edges of the orthogonal projections of the first openings 51 on the substrate 10.

For example, external light may pass through the plurality of first openings 51 in the light-shading layer 50 to enter an interior of the display substrate 100, and then pass through the display substrate 100 to enter the optical elements 200.

Therefore, in a process of the external light entering the optical element 200 through the first opening 51 in the secondary display region A2, block of the external light by the light-shading layer 50 may be avoided, and the external light is not easily blocked or even not be blocked by the first-type signal lines 41 and the first-type fan-out lines 44. As a result, the external light has a relatively small loss, thereby improving the light transmittance of the secondary display region A2 of the display substrate 100 and increasing the light collection amount of the optical element 200. Thus, it is beneficial to optimizing the performance of optical element 200, for example, improving the accuracy of fingerprint recognition by the fingerprint recognition sensor and improving the photography quality of the camera.

In an implementation, as shown in FIG. 5, the first-type fan-out line 44 is located between two adjacent data signal lines Data, and the first-type fan-out line 44 and the two data signal lines Data are disposed in the same layer. The first-type fan-out line 44 and the two data signal lines Data constitute parasitic capacitors. During jumping of a data signal transmitted by the data signal line Data, an electrical signal transmitted by the first-type fan-out line 44 will be affected by the jumping due to an influence of the parasitic capacitor, resulting in fluctuation of the electrical signal transmitted by the first-type fan-out line 44. Thus, the image display quality of the display substrate and the display apparatus may be affected.

In light of this, as shown in FIG. 6, in a display substrate 100 provided in some embodiments of the present disclosure, a first-type fan-out line 44 is provided between two adjacent first-type signal lines 41. There is no other signal line 40 provided between the first-type fan-out line 44 and the two adjacent first-type signal lines 41.

The first-type fan-out line 44 receives an electrical signal (e.g., a data signal) from the driver circuit board or the driver chip and transmits the electrical signal to pixel circuits 20. The first-type signal line 41 receives a constant voltage signal from the driver circuit board or the driver chip and transmits the constant voltage signal to pixel circuits 20.

The first-type signal line 41 transmitting the constant voltage signal has a certain shielding effect, and may separate the first-type fan-out line 44 from other signal lines 40. As a result, the first-type fan-out line 44 and any of the signal lines 40 (e.g., the above data signal line Data) other than the first-type signal line 41 have a relatively large distance therebetween. Therefore, the first-type signal line 41 is less affected by other signal lines 40, and the first-type fan-out line 44 is reduced or even avoided from being affected by the jumped electrical signal on the adjacent signal line 40 (e.g., the above data signal line Data). In this way, stability and accuracy of the electrical signal transmitted by the first-type fan-out signal line 40 may be improved, and the driving capability of the pixel circuits 20 may be enhanced, thereby improving the image display quality of the display substrate 100 and the display apparatus 1000.

The display substrate 100 provided by the embodiments of the present disclosure includes a substrate 10, a plurality of signal lines 40 and a light-shading layer 50. The light transmittance of the secondary display region A2 is greater than the light transmittance of the main display region A1. The signal lines 40 are at least located in the display area A. The light-shading layer 50 includes a plurality of first openings 51 located in the secondary display region A2. A plurality of first-type signal lines 41 in the plurality of signal lines 40 receive a constant voltage electrical signal. The orthographic projections of the plurality of first-type signal lines 41 and the plurality of first-type fan-out lines 44 on a plane where the substrate is located and the orthogonal projections of the plurality of first openings 51 on the plane where the substrate is located have no overlap. Thus, in a process of the external light passes through the display substrate 100 through the first opening 51, the external light is not easily blocked or even not be blocked by the first-type signal lines 41 and the first-type fan-out lines 44. The external light has a relatively small loss, thereby improving the light transmittance of the secondary display region A2 of the display substrate 100 and increasing the light collection amount of the optical element 200. Thus, it is beneficial to optimizing the performance of optical element 200, for example, improving the accuracy of fingerprint recognition by the fingerprint recognition sensor and improving the photography quality of the camera. Moreover, the first-type fan-out line 44 is provided between two adjacent first-type signal lines 41, so that the first-type signal line 41 is less affected by other signal lines 40, and the first-type fan-out line 44 is reduced or even avoided from being affected by the jumped electrical signal on the adjacent signal line 40 (e.g., the above data signal line Data). In this way, stability and accuracy of the electrical signal transmitted by the first-type fan-out signal line 40 may be improved, and the driving capability of the pixel circuits 20 may be enhanced, thereby improving the image display quality of the display substrate 100 and the display apparatus 1000.

In some examples, as shown in FIG. 6, the first-type signal lines 41 extend in the first direction Y, and the first-type fan-out lines 44 extend in the first direction Y.

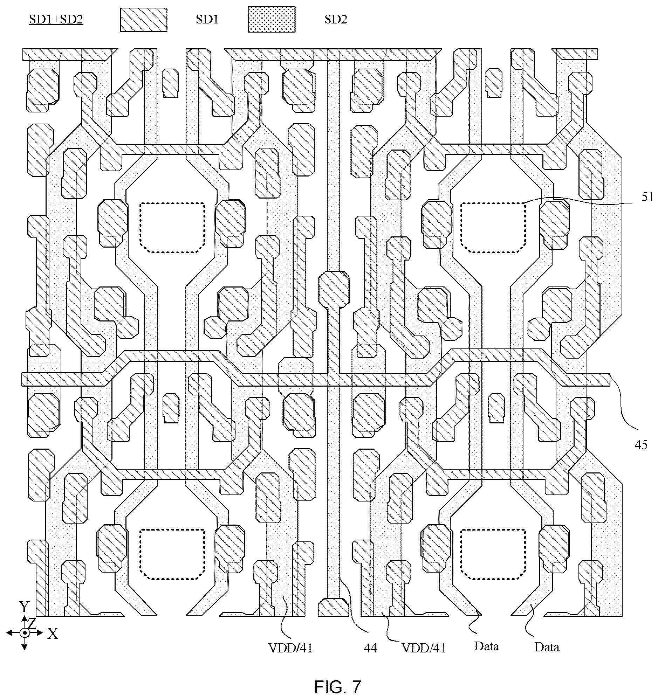

For example, as shown in FIG. 6, the first-type signal line 41 is substantially in a long strip shape, and the long strip extends in the first direction Y. As another example, as shown in FIG. 7, the first-type signal line 41 is in a zigzag shape, and an overall extension direction of the zigzag shape is substantially in the first direction Y.

For example, the first-type fan-out line 44 is substantially in a long strip shape, and the long strip extends in the first direction Y.

For example, the two adjacent first-type signal lines 41 and the first-type fan-out line 44 are parallel or substantially parallel.

For example, in the second direction X, a whole of the first-type signal line 41 and a whole of the first-type fan-out line 44 have a uniform distance therebetween. Specifically, an example is given, where the first-type fan-out line 44 includes multiple connected sub-sections and the multiple sub-sections include a first sub-section and a second sub-section, and the corresponding first-type signal line 41 includes multiple connected sub-sections and the multiple sub-sections include a third sub-section and a fourth sub-section. In the second direction X, the first sub-section is opposite to the third sub-section, and a dimension of the first sub-section in the first direction Y is approximately equal to a dimension of the third sub-section in the first direction Y. In the second direction X, the second sub-section is opposite to the fourth sub-section, and a dimension of the first sub-section in the first direction Y is approximately equal to a dimension of the third sub-section in the first direction Y. A distance between the first sub-section and the third sub-section is equal to or substantially equal to a distance between the second sub-section and the fourth sub-section.

As another example, in the second direction X, the first-type signal line 41 and the first-type fan-out line 44 have a non-uniform distance therebetween. Specifically, an example is given, where the first-type fan-out line 44 includes multiple connected sub-sections and the multiple sub-sections include a first sub-section and a second sub-section, and the corresponding first-type signal line 41 includes multiple connected sub-sections and the multiple sub-sections include a third sub-section and a fourth sub-section. The first sub-section corresponds to the third sub-section. The correspondence here means that in the second direction X, the first sub-section is opposite to the third sub-section, and a dimension of the first sub-section in the first direction Y is approximately equal to a dimension of the third sub-section in the first direction Y. The second sub-section corresponds to the fourth sub-section. The correspondence here means that in the second direction X, the second sub-section is opposite to the fourth sub-section and a dimension of the first sub-section in the first direction Y is approximately equal to a dimension of the third sub-section in the first direction Y. A distance between the first sub-section and the third sub-section is not equal to a distance between the second sub-section and the fourth sub-section.

For example, as shown in FIGS. 6 and 7, the first-type fan-out line 44 located between two adjacent first-type signal lines 41 and the two adjacent first-type signal lines 41 have equal or substantially equal distances.

For example, a distance between each sub-section of the first-type fan-out line 44 and a corresponding sub-section of a first-type signal line 41 on one side thereof is equal to or substantially equal to a distance between the sub-section of the first-type fan-out line 44 and a corresponding sub-section of another first-type signal line 41 on the other side thereof.

Therefore, the two first-type signal lines 41 may have the same or approximately the same shielding effects on opposite sides of the first fan-out line, so as to further reduce an influence on the first-type fan-out line 44 by jumping of the electrical signal on any other signal line 40, thereby effectively improving the stability and the accuracy of the electrical signal transmitted by the first-type fan-out signal line 40, improving the driving capability of the pixel circuits 20, and thus improving the image display quality of the display substrate 100.

Optionally, two adjacent first-type signal lines 41 located on opposite sides of the same first-type fan-out line 44 are substantially symmetrically arranged or symmetrically arranged with respect to the same first-type fan-out line 44.

For example, the first-type fan-out line 44 is a symmetry axis, and shapes of the two first-type signal lines 41 are symmetrical about the same first-type fan-out line 44.

In this way, two opposite sides of each sub-section of the first-type fan-out line 44 may be subjected to the same or approximately the same shielding effects, thereby further reducing the influence on the first-type fan-out line 44 by jumping of the electrical signal on any other signal line 40, and improving the stability and the accuracy of the electrical signal transmitted by the first-type fan-out signal line 40.

In some examples, as shown in FIG. 2, the display substrate 100 further includes the plurality of pixel circuits 20.

The structure of the pixel circuit 20 varies and may be set depending on actual needs. For example, the pixel circuit 20 may have a structure of "6T1C", "7T1C", "8T1C" or "7T2C". Here, "T" represents a transistor, and a number in front of "T" represents the number of the transistors, "C" represents a storage capacitor, and a number in front of "C" represents the number of the storage capacitor(s).

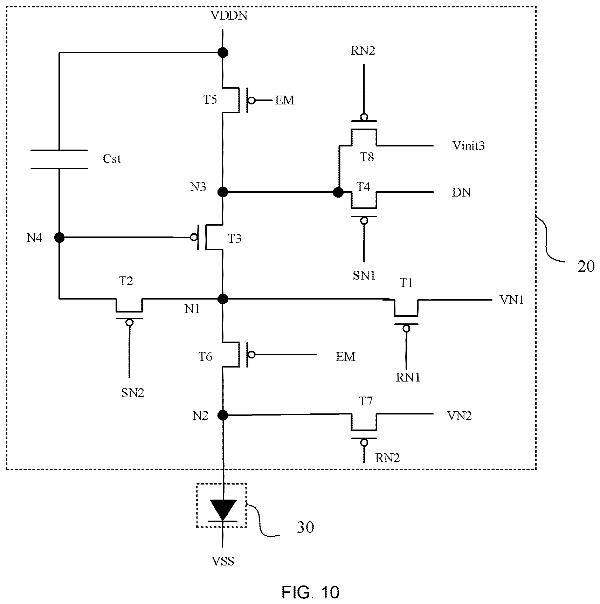

For example, the embodiments of the present disclosure will be described by considering an example where the structure of the pixel circuit 20 is an "8T1C" structure. FIG. 10 shows an equivalent circuit diagram of a sub-pixel.

In the pixel circuit provided in the embodiments of the present disclosure, a first electrode of each transistor is one of a source and a drain, and a second electrode of each transistor is the other of the source and the drain. Since the source and the drain of the transistor may be symmetrical in structure, the source and the drain may be structurally indistinguishable. That is, the first electrode and the second electrode of the transistor provided in the embodiments of the present disclosure may be indistinguishable in structure. For example, in a case where the transistor is a P-type transistor, the first electrode of the transistor is the source and the second electrode of the transistor is the drain. For example, in a case where the transistor is an N-type transistor, the first electrode of the transistor is the drain, and the second electrode of the transistor is the source. In the pixel circuit provided in the embodiments of the present disclosure, a first node, a second node, and other nodes do not represent actual components, but represent junctions of related electrical connections in a circuit diagram. That is, these nodes are nodes equivalent to the junctions of the related electrical connections in the circuit diagram.

For example, as shown in FIG. 10, the pixel circuit 20 includes a first reset transistor T1, a compensation transistor T2, a driving transistor T3, a switch transistor T4, a first light-emission control transistor T5, a second light-emission control transistor T6, a second reset transistor T7, a third reset transistor T8 and a storage capacitor Cst.

For example, as shown in FIG. 10, a control electrode of the first reset transistor T1 is electrically connected to a first reset signal terminal RN1, a first electrode of the first reset transistor T1 is electrically connected to a first initial signal terminal VN1, and a second electrode of the first reset transistor T1 is electrically connected to a first node N1 (i.e., electrically connected to a second electrode of the compensation transistor T2). The first reset transistor T1 is configured to be turned on under control of a first reset signal provided by the first reset signal terminal RN1 to transmit a first initial signal received at the first initial signal terminal VN1 to the first node N1, so as to reset the first node N1.

For example, as shown in FIG. 10, a control electrode of the second reset transistor T7 is electrically connected to a second reset signal terminal RN2, a first electrode of the second reset transistor T7 is electrically connected to a second initial signal terminal VN2, and a second electrode of the second reset transistor T7 is electrically connected to a second node N2. The second reset transistor T7 is configured to be turned on under control of a second reset signal provided by the second reset signal terminal RN2 to transmit a second initial signal received at the second initial signal terminal VN2 to the second node N2, so as to reset the second node N2.

For example, as shown in FIG. 10, a control electrode of the switch transistor T4 is electrically connected to a first scan signal terminal SN1, a first electrode of the switch transistor T4 is electrically connected to a data signal terminal DN, and a second electrode of the switch transistor T4 is electrically connected to a third node N3. The switch transistor T4 is configured to be turned on under control of a first scan signal provided by the first scan signal terminal SN1 to transmit a data signal transmitted by the data signal terminal DN to the third node N3.

For example, as shown in FIG. 10, a control electrode of the driving transistor T3 is electrically connected to a fourth node N4, a first electrode of the driving transistor T3 is electrically connected to the third node N3, and a second electrode of the driving transistor T3 is electrically connected to the first node N1. The driving transistor T3 is configured to be turned on under control of a voltage at the fourth node N4 to transmit a signal (e.g., the data signal) from the third node N3 to the first node N1.

For example, as shown in FIG. 10, a control electrode of the compensation transistor T2 is electrically connected to a second scan signal terminal SN2, a first electrode of the compensation transistor T2 is electrically connected to the first node N1, and a second electrode of the compensation transistor T2 is electrically connected to the fourth node N4. The compensation transistor T2 is configured to be turned on under control of a second scan signal provided by the second scan signal terminal SN2 to transmit an electrical signal (e.g., the data signal) from the first node N1 to the fourth node N4.

For example, as shown in FIG. 10, a control electrode of the first light-emission control transistor T5 is electrically connected to an enable signal terminal EM, a first electrode of the first light-emission control transistor T5 is electrically connected to a first voltage signal terminal VDD, and a second electrode of the first light-emission control transistor T5 is electrically connected to the third node N3. The first light-emission control transistor T5 is configured to be turned on under control of an enable signal provided by the enable signal terminal M to transmit a voltage signal received at the first voltage signal terminal VDD to the third node N3.

For example, as shown in FIG. 10, a control electrode of the second light-emission control transistor T6 is electrically connected to the enable signal terminal EM, a first electrode of the second light-emission control transistor T6 is electrically connected to the first node N1, and a second electrode of the second light-emission control transistor T6 is electrically connected to the second node N2. The second light-emission control transistor T6 is configured to be turned on under control of the enable signal provided by the enable signal terminal EM to transmit a voltage signal from the first node N1 to the second node N2.

For example, as shown in FIG. 10, a control electrode of the third reset transistor T8 is electrically connected to the second reset signal terminal RN2, a first electrode of the third reset transistor T8 is electrically connected to a third initial signal terminal VN3, and a second electrode of the third reset transistor T8 is electrically connected to the third node N3. The third reset transistor T8 is configured to be turned on under control of the second reset signal provided by the second reset signal terminal RN2 to transmit a third initial signal received at the third initial signal terminal VN3 to the third node N3.

For example, as shown in FIG. 10, a first electrode of the storage capacitor Cst is electrically connected to the fourth node N4, and a second electrode of the storage capacitor Cst is electrically connected to the first voltage signal terminal VDD.

An end of the light-emitting device 30 is electrically connected to the second node N2, and the other end of the light-emitting device 30 is electrically connected to a common voltage signal terminal VSS.

The light-emitting device 30 emits light due to action of an electrical signal provided at the second node N2 and a common voltage provided by the common voltage signal terminal VSS.

The compensation transistor T2 in the above pixel circuit 20 may be a low temperature polycrystalline oxide (LTPO) transistor, and the remaining transistors may be low temperature poly-silicon (LTPS) transistors.

For example, the LTPO transistor has a relatively low leakage current. Therefore, setting the compensation transistor T2 as an oxide transistor may reduce the leakage current of the compensation transistor T2, so as to avoid the electrical leakage of the fourth node N4 through the compensation transistor T2 and the first reset transistor T1. Furthermore, a compensation effect on the driving transistor T3 may be ensured, and the stability of the electrical signal at the fourth node N4 may be ensured, thereby improving the display quality of the display substrate 100. Moreover, the LTPS transistor has a relatively high mobility. Therefore, setting the driving transistor T3 and other transistors as low temperature poly-silicon transistors may accelerate the charging speed of the storage capacitor Cst, thereby further improving the display quality of the display substrate 100.

In an implementation, as shown in FIG. 5, a first-type signal line 41 is connected to two adjacent columns of pixel circuits.

In some embodiments of the present disclosure, as shown in FIGS. 6 and 7, two adjacent first-type signal lines 41 located on both sides of the first-type fan-out line 44 constitute a first-type signal line group 410. The two first-type signal lines 41 in the first-type signal line group 410 are connected. A first-type signal line 41 is electrically connected to a column of pixel circuits 20.

Therefore, based on the relative position of the pixel circuits 20 in the display area A, the position of the corresponding first-type signal line 41 may be set. As a result, the relative position of the first-type signal line 41 and the pixel circuits 20 connected thereto may be reasonably adjusted, thereby improving the design flexibility of the first-type signal line 41 and helping to reduce the design difficulty of the display substrate 100.

In some examples, as shown in FIG. 6, the plurality of signal lines 40 further include a plurality of first connecting lines 46. The first connecting lines 46 extend in the second direction X. The first connecting line 46 connects the two first-type signal lines 41 in the first-type signal line group 410.

For example, the first connecting line 46 and the corresponding first-type signal lines 41 are located in different layers.

The two first-type signal lines 41 in the first-type signal line group 410 extend in a different direction from the first connecting line 46, so that the plurality of first-type signal lines 41 and the plurality of first connecting lines 46 intersect with one another to form a mesh structure. Therefore, during transmitting an electrical signal by the first-type signal line 41, electrical signals transmitted to all the pixel circuits 20 in different rows in the same column have a small difference. In this way, a voltage drop of the electrical signal transmitted by the first-type signal line 41 may be reduced, and thus a difference between the light emitted by the sub-pixel and the preset light may be reduced, thereby improving the image display quality of the display substrate 100 and the display apparatus 1000.

In some examples, as shown in FIGS. 6 and 7, the first-type signal line 41 includes a first voltage signal line VDD. The first voltage signal line VDD transmits a first voltage signal to the pixel circuits 20 connected thereto.

In an implementation, as shown in FIG. 5, the first voltage signal line VDD in the display substrate 100 provides an electrical signal for two adjacent columns of pixel circuits. The first voltage signal line VDD has a relatively large dimension in the second direction X, that is, the first voltage signal line VDD is wide.

In the embodiments of the present disclosure, the first voltage signal line VDD in the above-mentioned implementation is divided into two first voltage signal lines VDD. The two first voltage signal lines VDD respectively provide or transmit first voltage signals for two adjacent columns of pixel circuits 20, and a first-type fan-out line 44 is provided between the two first voltage signal lines VDD. Thus, the two first voltage signal lines VDD may be used to shield and protect the first-type fan-out line 44. Moreover, a distance between a first voltage signal line VDD and a column of pixel circuits 20 connected thereto may be flexibly adjusted without being affected by the positions of other columns of pixel circuits 20, thereby helping to simplify the design of the display substrate 100.

In some examples, as shown in FIG. 2, the plurality of signal lines 40 further include a plurality of second-type signal lines 42. The second-type signal lines 42 and the first-type signal lines 41 are used to receive the same electrical signal. The plurality of second-type signal lines 42 have the same or substantially the same extension directions as the plurality of data lines DL.

For example, the second-type signal line 42 also includes a first voltage signal line VDD. The second-type signal line 42 is connected to one or two columns of pixel circuits 20 and provides a first voltage signal for the pixel circuits 20.

Compared with the second-type signal line 42, the first-type signal line 41 is closer to a center line CL of the display area A extending in the first direction Y.

Thus, the first-type fan-out line 44 located between two adjacent first-type signal lines 41 may be made close to the center line CL of the display area A, so as to reduce a distance between the first-type fan-out line 44 and the bonding region B in the second direction X, which is conducive to ensuring that the first-type fan-out line 44 extends to the bonding region B.

In some examples, as shown in FIGS. 2 and 6, the plurality of signal lines 40 further include a plurality of second-type fan-out lines 45 and a plurality of data signal lines Data. The data signal lines Data extend in the first direction Y, and the second-type fan-out lines 45 extend in the second direction X. The second-type fan-out lines 45 are located in the display area A. A second-type fan-out line 45 is connected to a first-type fan-out line 44. The data signal line Data is connected to the second-type fan-out line 45.

For example, the second-type fan-out line 45 and the first-type fan-out line 44 are connected through via hole(s), and the data signal line Data and the second-type fan-out line 45 are connected through via hole(s).

In a top view shown in FIG. 6, in the second direction X, an arrangement order of the plurality of signal lines 40 and the first openings 51 is as following: a first-type voltage signal line 41 (or a first voltage signal line VDD), a first-type fan-out line 44, a first-type voltage signal line 41 (or a first voltage signal line VDD), a data signal line Data, first openings 51, a data signal line Data, a first-type voltage signal line 41 (or a first voltage signal line VDD).

For example, in the plurality of data signal lines Data, a data signal line Data that is away from the center line CL of the display area A extending in the first direction Y is connected to a second-type fan-out line 45. The data signal line Data is connected to the first-type fan-out line 44 by the second-type fan-out line 45, so as to lead out the data signal line Data, thereby making it easy for the data signal line Data receive an electrical signal from the bonding region B.

The data signal lines Data connected to the second-type fan-out line 45 is a signal line in the display substrate 100 that need to be led out to the bonding region B by the second-type fan-out line 45 and the first-type fan-out line 44 in sequence. Such a provision may be called FIP (Fanout in Pixel). The data signal line Data has a relatively large distance from the center line CL of the display area A in the first direction Y, and is close to a boundary line between the display area A and the peripheral area B.

The provision of leading the data signal line Data to the bonding region B using the second-type fan-out line 45 and the first-type fan-out line 44 may allow an area in the peripheral area N occupied by the data signal line Data and the corresponding second-type fan-out line 45 and first-type fan-out line 44 small. Thus, an area of the peripheral area N of the display substrate 100 may be designed to be small, which is conducive to realizing a narrow frame design of the display substrate 100 and the display apparatus 1000.

At least one sub-section in the multiple sub-sections of the first-type fan-out line 44 is connected to the second-type fan-out line 45. For example, the multiple sub-sections of the first-type fan-out line 44 may be interconnected and uninterrupted. As another example, as shown in FIG. 6, in the multiple sub-sections 441 of the first-type fan-out line 44, at least two adjacent sub-sections 441 in a plurality of adjacent sub-sections 441 are disconnected from each other. A sub-section 441 of the first-type fan-out line 44 connected to the second-type fan-out line 45 is a valid sub-section of the first-type fan-out line 44, and a sub-section 441 of the first-type fan-out line 44 not connected to the second-type fan-out line 45 is a redundant sub-section of the first-type fan-out line 44. The redundant sub-section may receive a constant voltage signal, for example, receive a common voltage signal.

It can be understood that the display substrate 100 is further provided therein with data signal lines that are not connected to second-type fan-out lines 45 and first-type fan-out lines 44. These data signal lines extend in the first direction Y and have relatively small distances from the bonding region B in the second direction X, alternatively, these data signal lines are directly opposite to the bonding region B in the first direction Y. Therefore, these data signal lines extend directly to the bonding region B without using the first-type fan-out lines 44 and the second-type fan-out lines 45 for leading out.

In some examples, as shown in FIG. 2, the plurality of signal lines 40 further include a plurality of third-type signal lines 43. The third-type signal line 43 receives an initial signal and transmits the initial signal. The third-type signal lines 43 extend in the second direction X.

Two adjacent rows of pixel circuits 20 are connected to the same third-type signal line 43. Therefore, the two adjacent rows of pixel circuits 20 share one third-type signal line 43, so that the number of the third-type signal lines 43 may be reduced. As a result, an area occupied by the third-type signal lines 43 in a film layer where the third-type signal lines 43 are located may be reduced, thereby reducing the wiring difficulty of the film layer and reducing the manufacture cost of the display substrate 100.

For example, two adjacent rows of pixel circuits 20 are located on opposite sides of the same third-type signal line 43. Thus, distances between the third-type signal line 43 and the two rows of pixel circuits 20 may be reduced to a certain extent, so as to reduce the wiring difficulty of the third-type signal lines 43, thereby facilitating the manufacture difficulty of the display substrate 100.

In some examples, the two adjacent rows of pixel circuits 20 and the same third-type signal line 43 have equal or substantially equal distances therebetween.

The two adjacent rows of pixel circuits 20 may be symmetrically arranged with respect to the third-type signal line 43.

In this way, the third-type signal line 43 may be electrically connected to the two adjacent rows of pixel circuits 20 through equal or approximately equal paths, so that electrical signals transmitted by the third-type signal line 43 to the two rows of pixel circuits 20 have a relatively small difference or even no difference. As a result, in a case of the same preset brightness, the two rows of sub-pixels may emit light with small or even no difference, which is beneficial to improving the image display quality of the display substrate 100 and the display apparatus 1000, thereby being beneficial to improving the image display quality of the display substrate 100 and the display apparatus 1000. Moreover, the plurality of pixel circuits 20 may be arranged regularly, which is conducive to rational planning the relative position of the first openings 51, thereby increasing an area of the first opening 51, increasing the amount of light collected by the optical element 200, and improving the performance of the optical element 200 and the display apparatus 1000.

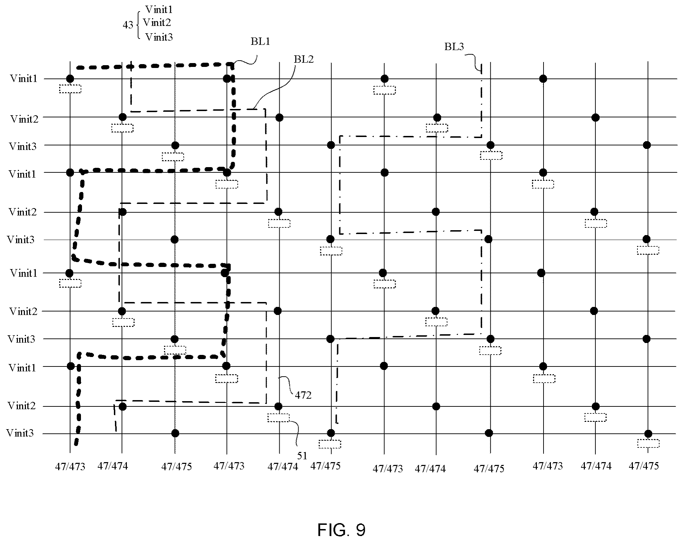

In some examples, as shown in FIGS. 2 and 9, the plurality of third-type signal lines 43 include a plurality of first initial signal lines Vinit1, a plurality of second initial signal lines Vinit2 and a plurality of third initial signal lines Vinit3.

For example, the first initial signal line Vinit1 and the second initial signal line Vinit2 are located on opposite sides of a row of pixel circuits 20, and the second initial signal line Vinit2 and the third initial signal line Vinit3 are located on the same side of the same row of pixel circuits 20.

For example, the plurality of rows of pixel circuits 20 include the first row of pixel circuits 20, the second row of pixel circuits 20, the third row of pixel circuits 20, the fourth row of pixel circuits 20 and the fifth row of pixel circuits 20 arranged in sequence in the first direction Y. A first initial signal line Vinit1 is located between the first row of pixel circuits 20 and the second row of pixel circuits 20, and the first row of pixel circuits 20 and the second row of pixel circuits 20 are symmetrically arranged about the first initial signal line Vinit1. A second initial signal line Vinit2 and a third initial signal line Vinit3 are both located between the second row of pixel circuits 20 and the third row of pixel circuits 20, and the second row of pixel circuits 20 and the third row of pixel circuits 20 are symmetrically arranged about the second initial signal line Vinit2 (or the third initial signal line Vinit3). Another first initial signal line Vinit1 is located between the third row of pixel circuits 20 and the fourth row of pixel circuits 20, and the third row of pixel circuits 20 and the fourth row of pixel circuits 20 are symmetrically arranged about the another first initial signal line Vinit1. Another second initial signal line Vinit2 and another third initial signal line Vinit3 are both located between the fourth row of pixel circuits 20 and the fifth row of pixel circuits 20, and the fourth row of pixel circuits 20 and the fifth row of pixel circuits 20 are symmetrically arranged about the another second initial signal line Vinit2 (or the another third initial signal line Vinit3).

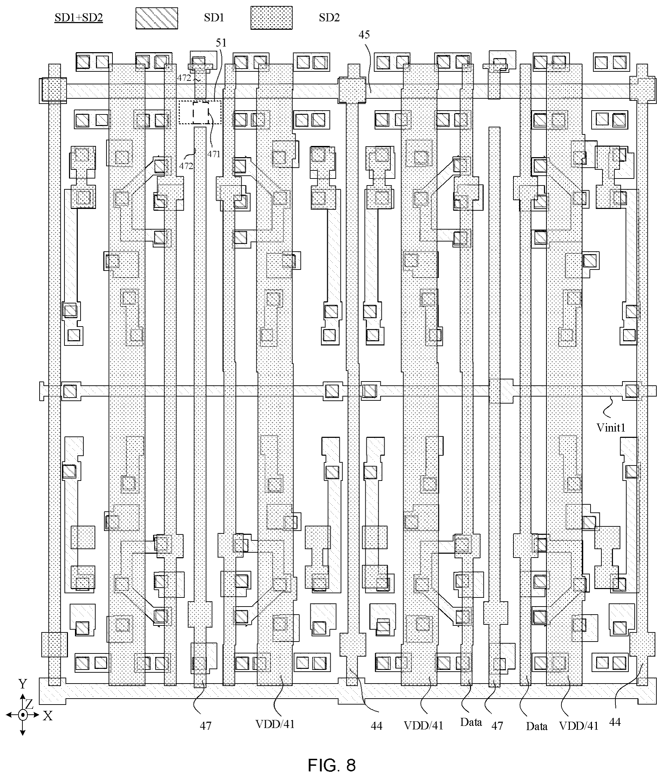

As shown in FIGS. 8 and 9, the plurality of signal lines 40 further include a plurality of second connecting lines 47. The plurality of second connecting lines 47 extend in the first direction Y.

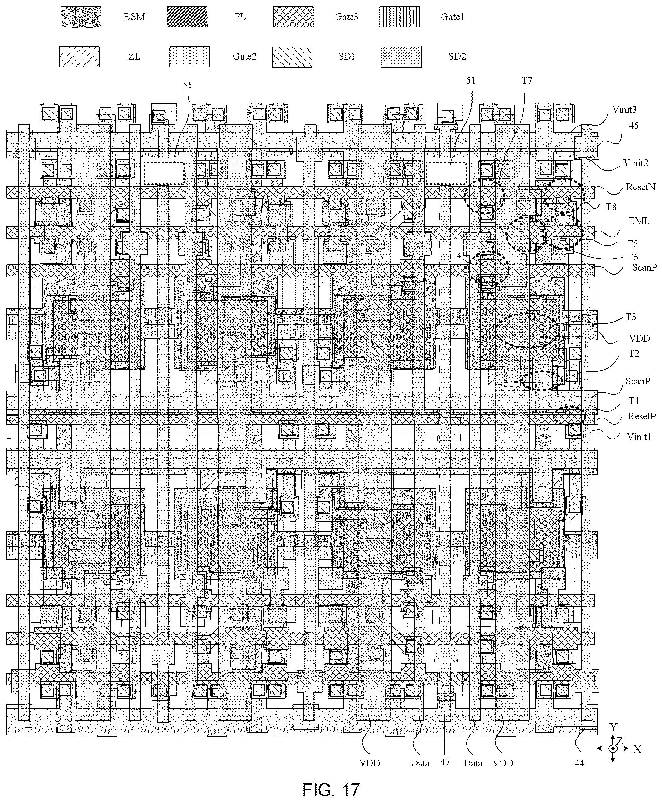

For example, as shown in FIG. 17, two adjacent columns of pixel circuits 20 located on opposite sides of the second connecting line 47 are symmetrically arranged with respect to the second connecting line 47. Two adjacent columns of pixel circuits 20 located on opposite sides of the first-type fan-out line 44 are symmetrically arranged with respect to the first-type fan-out line 44. In this way, the plurality of signal lines 40 and the plurality of pixels 20 may be arranged regularly, so that the relative position of the first openings 51 may be planned rationally. Thus, relatively large areas may be reserved for regions corresponding to the first openings 51, which is conducive to setting the areas of the first openings 51 to be relatively large areas. Furthermore, it is beneficial to increasing the light transmittance of the secondary display region A2, improving an opening ratio of the light-shading layer 50 (the opening ratio here refers to a ratio of an area of the plurality of first openings 51 to an entire area of the light-shading layer 50), increasing the amount of light collected by the optical elements 200, thereby improving the performance of the optical elements 200.

The second connecting line 47 is connected to at least one of the third-type signal lines 43. The structure of the second connecting line 47 varies and may be set depending on actual needs, and may not be limited in the embodiments of the present disclosure.

In some examples, as shown in FIG. 2, the second connecting line 47 is connected to a third-type signal line 43.

For example, the second connecting line 47 is a continuous and uninterrupted pattern.

The second connecting line 47 and the third-type signal line 43 have different extension directions and are connected to each other, so that the two may form a mesh structure in a local small region. In this way, during transmission of an electrical signal transmitted by the third-type signal line 43 to each pixel circuit 20, a voltage drop is small, and electrical signals transmitted by a third-type signal line 43 to each two adjacent rows of pixel circuits 20 have a relatively small difference or even no difference. Furthermore, the stability and the accuracy of the electrical signals transmitted by the third-type signal line 43 to each two adjacent rows of pixel circuits 20 may be ensured, so that the display substrate 100 may have a good image display effect.

In some other examples, as shown in FIGS. 8 and 9, the second connecting line 47 includes at least one break 471 and a plurality of sub-lines 472.

For example, the second connecting line 47 includes a break 471 and two sub-lines 472 located on both sides of the break 471.

As another example, the second connecting line 47 includes two breaks 471 and three sub-lines 472, where a sub-line 472 is located between two breaks 471, and the remaining two sub-lines 472 are located on both sides of the two breaks 471.

For example, the break 471 is directly opposite to the first opening 51, and a connecting line between the two sub-lines 472 on both sides of the break 471 passes through the first opening 51. In addition, a dimension of the break 471 in the first direction Y is greater than a dimension of the first opening 51 in the first direction Y. Therefore, it may be ensured that orthographic projections of the plurality of sub-lines 472 of the second connecting line 47 on the plane where the substrate 10 is located and orthogonal projections of the first opening 51 on the plane where the substrate 10 is located have no overlap regions. In a process of the external light passing through the display substrate 100 through the first opening 51, the loss caused by block of the external light by the plurality of sub-lines 472 may be reduced or even avoided, thereby increasing the amount of light collected by the optical element 200 and improving the performance of the optical element 200.

For example, each break 471 is provided with sub-lines 472 at opposite sides thereof. A sub-line 472 is connected to a third-type signal line 43.

As shown in FIG. 9, it may be understood that the plurality of sub-lines 472 of the same second connecting line 47 are connected to the same type of third-type signal lines 43 in the plurality of third-type signal lines 43. The same type of third-type signal lines 43 here refer to third-type signal lines 43 that transmit the same electrical signal. For example, the first initial signal line Vinit1 and the second initial signal line Vinit2 are different types of third-type signal lines. The first initial signal line Vinit1 and the third initial signal line Vinit3 are different types of third-type signal lines. The third initial signal line Vinit3 and the second initial signal line Vinit2 are different types of third-type signal lines.

For example, the plurality of second connecting lines 47 include a plurality of first-type connecting lines 473, a plurality of second-type connecting lines 474 and a plurality of third-type connecting lines 475.

The plurality of sub-lines 472 of the first-type connecting line 473 are respectively connected to a plurality of first initial signal lines Vinit1. The plurality of sub-lines 472 of the second-type connecting line 474 are respectively connected to a plurality of second initial signal lines Vinit2. The plurality of sub-lines 472 of the third-type connecting line 475 are respectively connected to a plurality of third initial signal lines Vinit3.

Therefore, a second connecting line 47 is connected to a plurality of third-type signal lines 43, so that a plurality of second connecting lines 47 and the plurality of third-type signal lines 43 form a mesh structure. As a result, during transmission of an electrical signal transmitted by the third-type signal line 43 to each pixel circuit 20, a voltage drop is small, so as to ensure the stability and the accuracy of the electrical signals transmitted by the third-type signal line 43 to each two adjacent rows of pixel circuits 20, so that the display substrate 100 may have a good image display effect.

In FIG. 9, the broken line BL1 illustrates a transmission path of the first initial signal transmitted by the first initial signal line Vinit1, the broken line BL2 illustrates a transmission path of the second initial signal transmitted by the second initial signal line Vinit2, and the broken line BL3 illustrates a transmission path of the third initial signal transmitted by the third initial signal line Vinit3.

In some examples, as shown in FIGS. 8 and 17, the second connecting line 47 is located between two adjacent data signal lines Data.

In a top view shown in FIG. 8, in the second direction X, an arrangement order of the plurality of signal lines 40 and the first openings 51 is as following: a first-type voltage signal line 41 (or a first voltage signal line VDD), a first-type fan-out line 44, a first-type voltage signal line 41 (or a first voltage signal line VDD), a data signal line Data, a first opening 51 and a second connecting line 47, a data signal line Data, a first-type voltage signal line 41 (or a first voltage signal line VDD).

For example, the second connecting line 47 is provided in the same layer as the two adjacent data signal lines Data.

Since the second connecting line 47 is connected to the third-type signal line 43, the second connecting line 47 transmits a constant voltage electrical signal. Thus, the second connecting line 47 may be used to shield the two adjacent data signal lines Data, so as to avoid mutual interference between data signals transmitted by the two adjacent data signal lines Data, and improve the stability and the accuracy of the data signals transmitted by the two adjacent data signal lines Data. As a result, the light emitted by the sub-pixel and the preset light may have a small difference, thereby improving the image display quality of the display substrate 100 and the display apparatus 100.

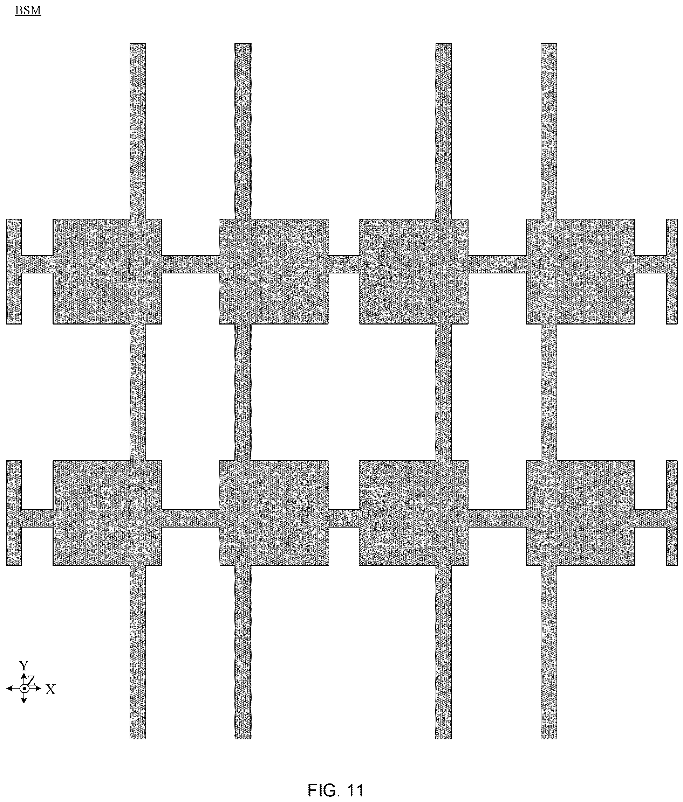

In some embodiments, as shown in FIGS. 11 to 17 and 8, the display substrate 100 includes: a shielding layer BSM, a first active layer PL, a third gate conductive layer Gate3, a first gate conductive layer Gate1, a second active layer ZL, a second gate conductive layer Gate2, a first source-drain conductive layer SD1 and a second source-drain conductive layer SD2 that are sequentially disposed on a side of the substrate 10.

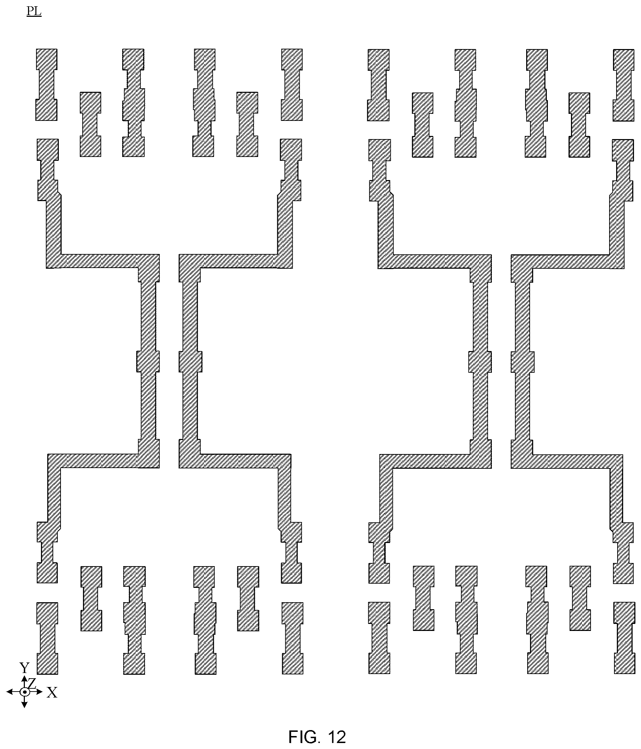

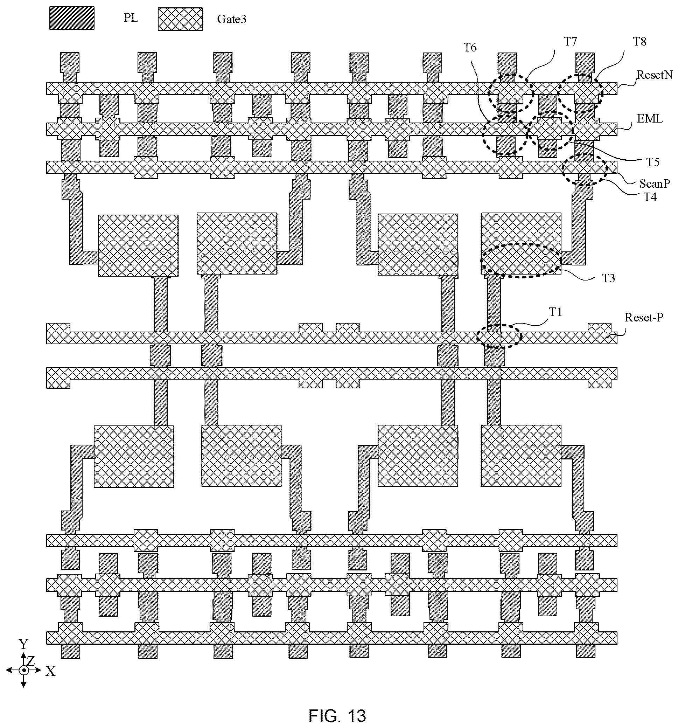

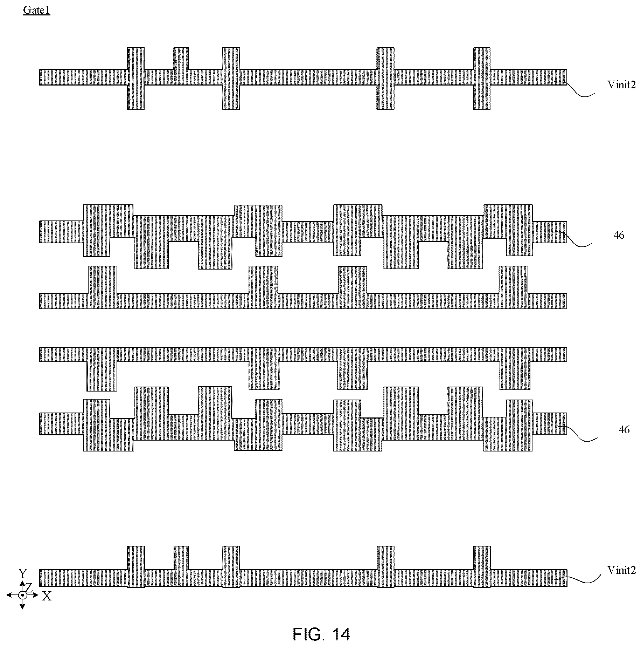

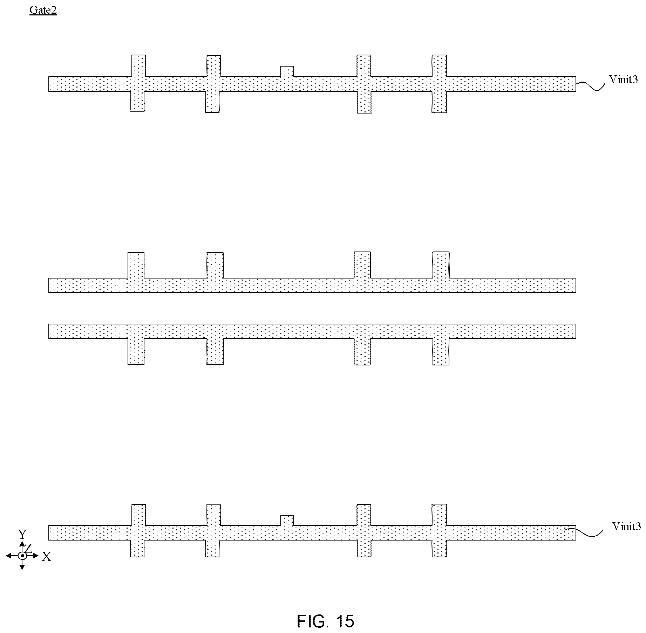

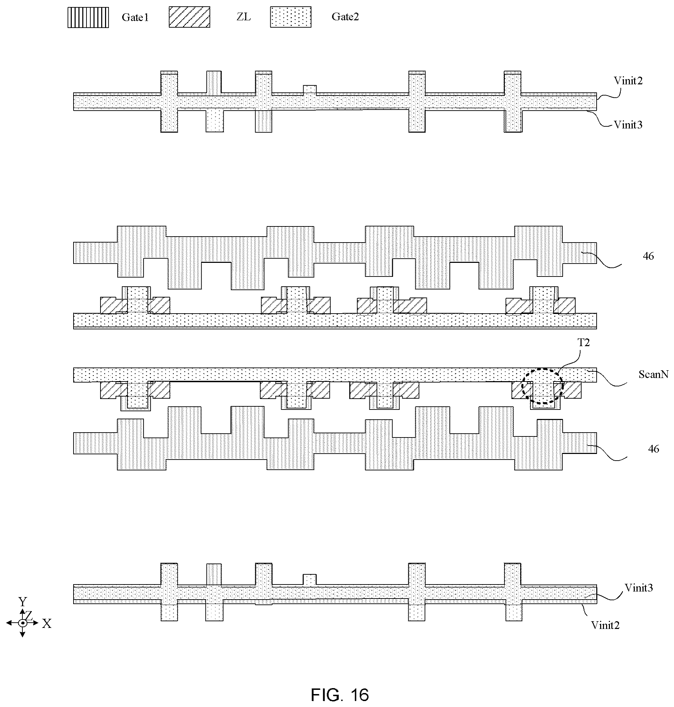

FIG. 11 shows a top view of a structure of the shielding layer BSM. FIG. 12 shows a top view of a structure of the first active layer PL. FIG. 13 shows a top view of a stacked structure of the first active layer PL and the third gate conductive layer Gate3. FIG. 14 shows a top view of a structure of the first gate conductive layer Gate1. FIG. 15 shows a top view of a structure of the second gate conductive layer Gate2. FIG. 16 shows a top view of a stacked structure of the first gate conductive layer Gate1, the second active layer ZL and the second gate conductive layer Gate2. FIG. 8 shows a top view of a stacked structure of the first source-drain conductive layer SD1 and the second source-drain conductive layer SD2. FIG. 17 shows a top view of a stacked structure of the shielding layer BSM, the first active layer PL, the third gate conductive layer Gate3, the first gate conductive layer Gate1, the second active layer ZL, the second gate conductive layer Gate2, the first source-drain conductive layer SD1 and the second source-drain conductive layer SD2.

It can be understood that FIG. 6 shows a top view of another stacked structure of the first source-drain conductive layer SD1, the second source-drain conductive layer SD2 and the light-shading layer 50. FIG. 7 shows a top view of another stacked structure of the first source-drain conductive layer SD1 and the second source-drain conductive layer SD2.

A material of the shielding layer BSM may include a conductive material. The shielding layer BSM may be connected to a signal line that transmits a constant voltage electrical signal (e.g., a first voltage signal line VDD, a common voltage signal line VSS, a first initial signal line Vinit1, a second initial signal line Vinit2 or a third initial signal line Vinit3), so as to improve stability of an electrical signal of a film layer (e.g., a film layer where a gate of the driving transistor T4 is located) located on a side of the shielding layer BSM away from the substrate 10, thereby preventing the signal of the film layer from being interfered.

For example, a material of the first active layer PL may include a semiconductor material such as amorphous silicon, monocrystalline silicon and polycrystalline silicon.

For example, a material of the second active layer ZL may include a metal oxide semiconductor material such as indium gallium zinc oxide (IGZO).

For example, materials of the first gate conductive layer Gate1, the second gate conductive layer Gate2, the third gate conductive layer Gate3, the first source-drain conductive layer SD1 and the second source-drain conductive layer SD2 are all conductive materials. For example, the materials of the first gate conductive layer Gate1, the second gate conductive layer Gate2 and the third gate conductive layer Gate3 may be the same, and the materials of the first source-drain conductive layer SD1 and the second source-drain conductive layer SD2 may be the same.

For example, the conductive material may be a metal material, such as aluminum (Al), silver (Ag), copper (Cu) and chromium (Cr).

It will be noted that an orthographic projection of the first active layer PL on the substrate 10 overlaps with orthographic projections of the third gate conductive layer Gate3 on the substrate 10. After the first gate conductive layer Gate1 is formed on a side of the first active layer PL away from the substrate 10, doping treatment is performed on the first active layer PL using the third gate conductive layer Gate3 as a mask. As a result, portions of the first active layer PL covered by the third gate conductive layer Gate3 constitute active patterns of some transistors, and portions of the first active layer PL not covered by the third gate conductive layer Gate3 constitute conductors, where the conductors may serve as first electrodes or second electrodes of some transistors. Portions of the third gate conductive layer Gate3 overlapped with the first active layer PL constitute gate patterns of some transistors.

In addition, an orthographic projection of the second active layer ZL on the substrate 10 and orthographic projections of the second gate conductive layer Gate2 on the substrate 10 have the same overlapping patterns as the orthographic projection of the second active layer ZL on the substrate 10 and orthographic projections of the first gate conductive layer Gate1 on the substrate 10. Portions of the second gate conductive layer Gate2 located within the same overlapping patterns and portions of the first gate conductive layer Gate1 located within the same overlapping patterns constitute gate patterns of some transistors, and portions of the second active layer ZL connected to the same overlapping patterns constitute first electrodes or second electrodes of some transistors.

It can be understood that in a plurality of film layers as mentioned above, an insulating layer (not shown in the figures) may be provided between any two adjacent film layers. The figures only illustrate positions of some via holes in the insulating layer. Each insulating layer may isolate conductive film layers (the conductive film layers here refer to the shielding layer BSM, the first active layer PL, the third gate conductive layer Gate3, the first gate conductive layer Gate1, the second active layer ZL, the second gate conductive layer Gate2, the first source-drain conductive layer SD1 and the second source-drain conductive layer SD2) located on opposite sides thereof, so as to avoid short circuits between the conductive film layers located on opposite sides of each insulating layer. Conductive film layers may be connected through via hole(s) extending through insulating layers. For example, materials of the insulating layers may include silicon oxide, silicon nitride or silicon oxynitride.

In an implementation, the plurality of signal lines (here referring to a plurality of second-type fan-out lines 45, a plurality of first-type signal lines 41, a plurality of first-type fan-out lines 44, a plurality of data signal lines Data, a plurality of second connecting lines 47 and a plurality of second-type signal lines 42) are disposed in three different film layers (e.g., the first source-drain conductive layer SD1, the second source-drain conductive layer SD2 and a third source-drain conductive layer) of the display substrate 100. Thus, the number of film layers in the display substrate 100 is relatively large, and an overall thickness of the display substrate 100 is relatively large, which is not conducive to the light and thin design of the display substrate 100. Moreover, masks used for forming the three film layers take relatively high costs, which is not conducive to reducing the manufacture cost of the display substrate 100.

In some examples of the present disclosure, as shown in FIGS. 8 and 17, the plurality of second-type fan-out lines 45 are located in the first source-drain conductive layer SD1. The plurality of first-type signal lines 41, the plurality of first-type fan-out lines 44 and the plurality of data signal lines Data are located in the second source-drain conductive layer SD2.

Therefore, the plurality of first-type signal lines 41, the plurality of first-type fan-out lines 44 and the plurality of data signal lines Data may be located in the same layer, which is beneficial to improving a shielding protection effect of the first-type signal lines 41 on the first-type fan-out lines 44.

As shown in FIG. 8, the plurality of second connecting lines 47 are located in the second source-drain conductive layer SD2. The plurality of first initial signal lines Vinit1 are located in the first source-drain conductive layer SD1. As shown in FIG. 14, the plurality of second initial signal lines Vinit2 and the first connecting lines 46 are located in the first gate conductive layer Gate1. As shown in FIG. 15, the plurality of third initial signal lines Vinit3 are located in the second gate conductive layer Gate2.

The first initial signal lines Vinit1, the second initial signal lines Vinit2 and the third initial signal lines Vinit3 are located in different film layers, and thus a wiring density of each film layer may be reduced to a certain extent. The first initial signal lines Vinit1, the second initial signal lines Vinit2 and the third initial signal lines Vinit3 are each located in different film layers from the second connecting lines 47, so that the first initial signal lines Vinit1 and the second connecting lines 47, the second initial signal lines Vinit2 and the second connecting lines 47, and the third initial signal lines Vinit3 and the second connecting lines 47 do not interfere with each other.

The plurality of data signal lines Data and the plurality of second connecting lines 47 are all located in the second source-drain conductive layer SD2. The second connecting line 47 is located between two adjacent data signal lines Data, so that the second connecting line 47 may be used to shield and protect the two adjacent data signal lines Data.

Therefore, the plurality of signal lines 40 may be disposed in the first source-drain conductive layer SD1 and the second source-drain conductive layer SD2 of the display substrate 100, so as to reduce the number of film layers in the display substrate 100 and reduce the thickness of the display substrate 100, thereby realizing the light and thin design of the display substrate 100 and the display apparatus 1000. Moreover, a mask may further be saved, thereby reducing the manufacture cost of the display substrate 100 and the display apparatus 1000.

In some other examples, as shown in FIG. 6, the plurality of first connecting lines 46 are located in the first source-drain conductive layer SD1. Therefore, a wiring density of the first gate conductive layer Gate1 may be reduced to a certain extent.

In some examples, the plurality of signal lines 40 further include: a plurality of enable signal lines EML, a plurality of first scan signal lines ScanP, a plurality of second scan signal lines ScanN, a plurality of first reset signal lines ResetP and a plurality of second reset signal lines ResetN.

The enable signal lines EML, the first scan signal lines ScanP, the second scan signal lines ScanN, the first reset signal lines ResetP and the second reset signal lines ResetN all extend in the second direction X.

The first scan signal lines ScanP, the second scan signal lines ScanN, the first reset signal lines ResetP and the second reset signal lines ResetN may all be connected to the gate driver circuit(s) to receive electrical signals from the gate driver circuit(s).

The enable signal line EML may be connected to an enable driver circuit (EM GOA) located in the peripheral area N of the display substrate 100 to receive an enable signal from the enable driver circuit.

For example, as shown in FIG. 13, the plurality of enable signal lines EML, the plurality of first scan signal lines ScanP, the plurality of first reset signal lines ResetP, and the plurality of second reset signal lines ResetN are all located in the third gate conductive layer Gate3.

As shown in FIG. 16, the plurality of second scan signal lines ScanN are located in the first gate conductive layer Gate1 and the second gate conductive layer Gate2.

For example, the data signal line Data is connected to a data signal terminal DN in the pixel circuit 20 and is used to transmit a data signal to the switch transistor T4 in the pixel circuit 20. The first voltage signal line VDD is connected to a first voltage signal terminal VDDN in the pixel circuit 20 and is used to transmit a first voltage signal to the first light-emitting control transistor T5 and the storage capacitor Cst in the pixel circuit 20.

The enable signal line EML is connected to an enable signal terminal EM in the pixel circuit 20 and is used to transmit an enable signal to the first light-emission control transistor T5 and the second light-emission control transistor T6 in the pixel circuit 20. The first scan signal line ScanP is connected to a first scan signal terminal SN1 in the pixel circuit 20 and is used to transmit a first scan signal to the switch transistor T4 in the pixel circuit 20. The second scan signal line ScanN is connected to a second scan signal terminal SN2 in the pixel circuit 20 and is used to transmit a second scan signal to the compensation transistor T2 in the pixel circuit 20.

The first initial signal line Vinit1 is connected to a first initial signal terminal VN1 in the pixel circuit 20, and is used to transmit a first initial signal to the first reset transistor T1 in the pixel circuit 20. The second initial signal line Vinit2 is connected to a second initial signal terminal VN2 in the pixel circuit 20, and is used to transmit a second initial signal to the second reset transistor T7 in the pixel circuit 20. The third initial signal line Vinit3 is connected to a third initial signal terminal VN3 in the pixel circuit 20, and is used to transmit a third initial signal to the third reset transistor T8 in the pixel circuit 20.

As shown in FIG. 3, the display substrate 100 further includes an encapsulation layer 60 provided on a side of the light-emitting devices 30 away from the substrate 10 and located between the light-shading layer 50 and the plurality of light-emitting devices 30.

For example, the encapsulation layer 60 may be a thin film encapsulation layer, and the thin film encapsulation layer may encapsulate the above-mentioned sub-pixels. As a result, the pixel circuits 20 and the light-emitting devices 30 are isolated from external moisture, thereby improving the luminous performance and the luminous life of the light-emitting devices 30, and avoiding oxidation of the pixel circuits 20 and the light-emitting devices 30 by the moisture in an event of the moisture invasion.

The encapsulation layer 60 has a certain light transmittance, so that the light emitted by the light-emitting device 30 may pass through the encapsulation layer 60 for exit.

The encapsulation layer 60 includes inorganic encapsulation layer(s) and an organic encapsulation layer that are stacked. The inorganic encapsulation layer(s) may include a first inorganic encapsulation layer and a second inorganic encapsulation layer. The organic encapsulation layer may be located between the first inorganic encapsulation layer and the second inorganic encapsulation layer.

For example, a material of the inorganic encapsulation layer is an inorganic material, and the inorganic encapsulation layer may be formed by vapor deposition. A material of the organic encapsulation layer is an organic material, and the organic encapsulation layer may be formed by inkjet printing. The material of the inorganic encapsulation layer may be optically clear (OC) adhesive.

It can be understood that the organic encapsulation layer is mainly used for planarization and stress relief, and the first inorganic encapsulation layer and the second inorganic encapsulation layer in the inorganic encapsulation layer(s) are mainly used to block moisture and oxygen and to wrap the organic encapsulation layer located between the first inorganic encapsulation layer and the second inorganic encapsulation layer.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A display substrate having a display area and a bonding region, the bonding region being located on a side of the display area in a first direction; the display substrate comprising:
a substrate;
a plurality of signal lines located on the substrate, wherein the signal lines are located at least in the display area; the plurality of signal lines include a plurality of first-type signal lines and a plurality of first-type fan-out lines; and the first-type signal lines receive a constant voltage electrical signal; and
a light-shading layer located on a side of the plurality of signal lines away from the substrate and located in the display area; the light-shading layer including a plurality of first openings, wherein
the display area includes a main display region and a secondary display region located on a side of the main display region; light transmittance of the secondary display region is greater than light transmittance of the main display region; the plurality of first openings are located in the secondary display region; orthographic projections of the plurality of first-type signal lines and the plurality of first-type fan-out lines on the substrate and orthogonal projections of the plurality of first openings on the substrate have no overlap; and a first-type fan-out line is located between two adjacent first-type signal lines.

2. The display substrate according to claim 1, wherein the first-type signal lines extend in the first direction, and the first-type fan-out lines extend in the first direction; and
the first-type fan-out line located between the two adjacent first-type signal lines and the two adjacent first-type signal lines have substantially equal or equal distances.

3. The display substrate according to claim 2, wherein the two adjacent first-type signal lines located on opposite sides of the first-type fan-out line are arranged substantially symmetrically or symmetrically with respect to the first-type fan-out line.

4. The display substrate according to claim 2 or 3, further comprising a plurality of pixel circuits, wherein the plurality of pixel circuits are arranged in a plurality of rows and a plurality of columns; each row of pixel circuits is arranged in a second direction, and each column of pixel circuits is arranged in the first direction, the second direction intersects the first direction; and
the two adjacent first-type signal lines located on both sides of the first-type fan-out line constitute a first-type signal line group, and the two first-type signal lines in the first-type signal line group are connected; and a first-type signal line is electrically connected to a column of pixel circuits.

5. The display substrate according to claim 4, wherein the plurality of signal lines further include a plurality of first connecting lines; the first connecting lines extend in the second direction; and a first connecting line connects the two first-type signal lines in the first-type signal line group.

6. The display substrate according to claim 1, wherein the first-type signal lines include a first voltage signal line.

7. The display substrate according to claim 1, wherein the plurality of signal lines further include a plurality of second-type signal lines; the second-type signal lines and the first-type signal lines are configured to receive the same electrical signal; and the second-type signal lines have same or substantially same extension directions as the first-type signal lines; and
compared with the second-type signal lines, the first-type signal lines are closer to a center line of the display area extending in the first direction.

8. The display substrate according to claim 1, wherein the plurality of signal lines further include a plurality of second-type fan-out lines and a plurality of data signal lines; the data signal lines extend in the first direction, the second-type fan-out lines extend in a second direction, and the second-type fan-out lines are located in the display area; a second-type fan-out line is connected to the first-type fan-out line; and
a data signal line is connected to the second-type fan-out line.

9. The display substrate according to claim 1, further comprising a plurality of pixel circuits, wherein the plurality of pixel circuits are arranged in a plurality of rows and a plurality of columns; each row of pixel circuits is arranged in a second direction, and each column of pixel circuits is arranged in the first direction, the second direction intersects the first direction;
the plurality of signal lines further include a plurality of third-type signal lines; the third-type signal lines are configured to receive an initial signal; and the third-type signal lines extend in the second direction; and
two adjacent rows of pixel circuits are connected to a same third-type signal line.

10. The display substrate according to claim 9, wherein the two adjacent rows of pixel circuits and the same third-type signal line have equal or substantially equal distances therebetween.

11. The display substrate according to claim 9, wherein the plurality of third-type signal lines include a plurality of first initial signal lines, a plurality of second initial signal lines and a plurality of third initial signal lines.

12. The display substrate according to claim 9, wherein the plurality of signal lines further include a plurality of second connecting lines; the second connecting lines extend in the first direction; and a second connecting line is connected to a third-type signal line.

13. The display substrate according to claim 9, wherein the plurality of signal lines further include a plurality of second connecting lines; and the second connecting lines extend in the first direction;
a second connecting line includes at least one break and a plurality of sub-lines; and
a break is directly opposite to a first opening, and a dimension of the break in the first direction is greater than or equal to a dimension of the first opening in the first direction; each break is provided with sub-lines at opposite sides thereof; and a sub-line is connected to a third-type signal line.

14. The display substrate according to claim 12, wherein the plurality of signal lines further include a plurality of data signal lines, and the second connecting line is located between two adjacent data signal lines.

15. The display substrate according to claim 1, wherein the display substrate comprises a first source-drain conductive layer and a second source-drain conductive layer that are arranged sequentially on a side of the substrate;
the display substrate further comprises a plurality of second-type fan-out lines and a plurality of data signal lines, wherein
the plurality of second-type fan-out lines are located in the first source-drain conductive layer; the plurality of first-type signal lines, the plurality of first-type fan-out lines and the plurality of data signal lines are located in the second source-drain conductive layer.

16. The display substrate according to claim 15, further comprising a first gate conductive layer and a second gate conductive layer that are arranged sequentially between the substrate and the first source-drain conductive layer, wherein the first gate conductive layer is located between the substrate and the second gate conductive layer;
the display substrate further comprises a plurality of first connecting lines, a plurality of second connecting lines, and a plurality of third-type signal lines; and the plurality of third-type signal lines include a plurality of first initial signal lines, a plurality of second initial signal lines and a plurality of third initial signal lines, wherein
the plurality of second connecting lines are located in the second source-drain conductive layer;
the plurality of first initial signal lines are located in the first source-drain conductive layer; and
the plurality of second initial signal lines and the plurality of first connecting lines are located in the first gate conductive layer, and the plurality of third initial signal lines are located in the second gate conductive layer.

17. The display substrate according to claim 1, further comprising a plurality of filter portions, wherein the light-shading layer further includes a plurality of second openings; the plurality of second openings are located in the main display region, and a filter portion is located in a second opening.

18. The display substrate according to any one of claims 1 to 17, further comprising:
a plurality of light-emitting devices located on a side of the plurality of signal lines away from the substrate; and
an encapsulation layer disposed between the light-shading layer and the plurality of light-emitting devices.

19. A display apparatus, comprising the display substrate according to any one of claims 1 to 18; and
an optical element located on a non-light-exit side of the display substrate and located in the secondary display region of the display substrate.
